# EUROPEAN PATENT APPLICATION

(11) **EP 4 586 594 A2**
(43) Date of publication of application: **16.07.2025**
(21) Application number: 25180391.2
(22) Date of filing: 26.04.2024
(51) Int. Cl.: H04M 1/02

(54) **ELECTRONIC DEVICE COMPRISING THERMAL DIFFUSION MEMBER**

(30) Priority: 26.04.2023 KR 20230054844; 31.05.2023 KR 20230069890; 25.04.2024 KR 20240055562
(62) Divisional of application: 24797461.1
(71) Applicant: Samsung Electronics Co., Ltd., Suwon-si, Gyeonggi-do 16677 (KR)
(72) Inventor: Moon, Heecheul, 16677 Suwon-si, Gyeonggi-do (KR); Kim, Sangmin, 16677 Suwon-si, Gyeonggi-do (KR); Baek, Moohyun, 16677 Suwon-si, Gyeonggi-do (KR); Lee, Seunghoon, 16677 Suwon-si, Gyeonggi-do (KR)
(74) Representative: Gulde & Partner

(57) **Abstract**

An electronic device according to an embodiment of the present disclosure may include a housing, a display disposed on the housing, a printed circuit board disposed in an interior of the housing, a battery including a first area and a second area having a thickness that is less than a thickness of the first area, and a thermal diffusion member disposed between the printed circuit board and the display and between the battery and the display, wherein the thermal diffusion member may include a first diffusion area and a second diffusion area extending to be overlapped with at least a portion of the second area.

## Description

### [Technical Field]

The present disclosure relates to an electronic device including a thermal diffusion member.

### [Background Art]

Electronic devices (e.g., portable electronic devices) may include structures for thermal diffusion within them. For example, an electronic device may diffuse heat generated by a printed circuit board to an area where a battery is positioned using a thermal diffusion member.

The thermal diffusion member may be disposed between internal components of the electronic device. For example, the thermal diffusion member may be disposed to extend between the printed circuit board and the display and between the battery and the display with a predetermined thickness.

### [Disclosure of Invention]

### [Technical Problem]

Because of the miniaturization of electronic devices, electronic devices may only include a thermal diffusion member with a predetermined thickness. However, a thermal diffusion member with a predetermined thickness may not be sufficient to improve the thermal diffusion performance of an electronic device.

Therefore, there may be a need for thermal diffusion structures that can improve the thermal diffusion performance of electronic devices.

### [Solution to Problem]

An electronic device according to an embodiment of the present disclosure may include a housing; a display disposed on one surface of the housing; a printed circuit board disposed in an interior of the housing; a battery disposed in one direction of the printed circuit board in the interior of the housing and including a first area and a second area having a thickness that is less than a thickness of the first area and formed at an end facing the printed circuit board; and a thermal diffusion member disposed between the printed circuit board and the display and between the battery and the display, wherein the thermal diffusion member may include a first diffusion area at least a portion of which is disposed to be overlapped with the printed circuit board and at least a portion of which extends to be disposed in the first area of the battery; and a second diffusion area disposed between the second area of the battery and the first diffusion area and extending to be overlapped with at least a portion of the second area.

An electronic device according to an embodiment of the present disclosure may include a housing; a display disposed on one surface of the housing; a printed circuit board disposed in an interior of the housing; a battery disposed in one direction of the printed circuit board in the interior of the housing and including a first area and a second area having a thickness that is less than a thickness of the first area and formed at an end facing the printed circuit board; and a thermal diffusion member disposed between the printed circuit board and the display and between the battery and the display, wherein the thermal diffusion member may include a first diffusion area at least a portion of which is disposed to be overlapped with the printed circuit board and at least a portion of which extends to be disposed in the first area of the battery; and a second diffusion area extending between the second area of the battery and the first diffusion area in a direction perpendicular to the direction in which the first diffusion area extends, and being overlapped with at least portion of the second area.

### [Advantageous Effects of Invention]

An electronic device according to an embodiment of the present disclosure may enhance the thermal diffusion performance of the electronic device by including an additional thermal diffusion member disposed in a protection circuit module (PCM) area of the battery.

An electronic device according to an embodiment of the present disclosure may enhance the thermal diffusion performance of the electronic device by including an additional thermal diffusion member at least a portion of which extends in a height direction of the electronic device.

An electronic device according to an embodiment of the present disclosure may enhance the rigidity of the electronic device by including a support area in which at least a portion of the thermal diffusion member is disposed.

The electronic device according to an embodiment of the present disclosure may extend the battery in the direction where the camera and printed circuit board are positioned by utilizing the protection circuit module (PCM) area of the battery as a space where the flexible printed circuit board is disposed.

### [Brief Description of Drawings]

FIG. 1 is a block diagram of an electronic device in a networked environment according to an embodiment.
FIGS. 2a and 2b are perspective views of an electronic device according to an embodiment of the present disclosure.
FIG. 3 is an exploded perspective view of an electronic device according to an embodiment of the present disclosure.
FIGS. 4a, 4b, 4c, and 4d are diagrams illustrating a housing, a battery, a thermal diffusion member, and a flexible printed circuit board according to an embodiment of the present disclosure.
FIG. 5 is a diagram illustrating a battery and a thermal diffusion member disposed in a housing according to an embodiment of the present disclosure.
FIGS. 6a and 6b are diagrams illustrating the electronic device as viewed from the A-A' cross-section shown in FIG. 5.
FIG. 7 is an exploded perspective view of an electronic device according to an embodiment of the present disclosure.
FIG. 8 is a diagram illustrating a thermal diffusion member according to an embodiment of the present disclosure.
FIG. 9 is a diagram illustrating a housing according to an embodiment of the present disclosure.
FIG. 10 is a diagram illustrating a support area of a housing according to an embodiment of the present disclosure.
FIG. 11 is an exploded perspective view of an electronic device according to an embodiment of the present disclosure.
FIG. 12 is a diagram illustrating an electronic device according to an embodiment of the present disclosure.
FIG. 13 is a cross-sectional perspective view of an electronic device according to an embodiment of the present disclosure.
FIGS. 14A and 14B are front and rear views of an unfolded electronic device according to an embodiment of the disclosure.
FIGS. 15A and 15B are front and rear views of the folded electronic device according to an embodiment of the disclosure.
FIG. 16 is an exploded perspective view of an electronic device according to an embodiment of the disclosure.
FIGS. 17A, 17B, and 17C are views illustrating an unfolded state of an electronic device according to an embodiment of the disclosure.
FIG. 18A is a perspective view of an electronic device illustrating a folded state according to an embodiment of the disclosure.
FIG. 18B is a perspective view of an electronic device illustrating an intermediate state of the electronic device according to an embodiment of the disclosure.
FIG. 19 is an exploded perspective view of an electronic device according to an embodiment of the disclosure.

### [Mode for the Invention]

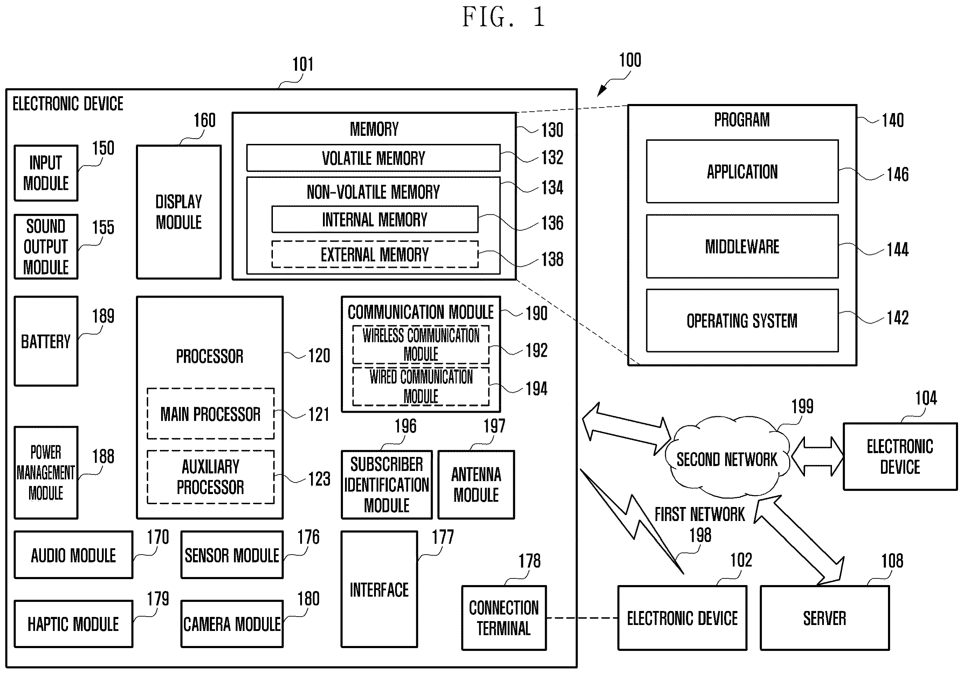

FIG. 1 is a block diagram of an electronic device 101 in a network environment 100 according to an embodiment. With reference to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In some embodiments of the disclosure, at least one (e.g., the connection terminal 178) of the components may be omitted from the electronic device 101, or one or more other components may be added in the electronic device 101. In some embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for slide-in calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5^{th} generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4^{th} generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to an embodiment of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input/output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In an embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

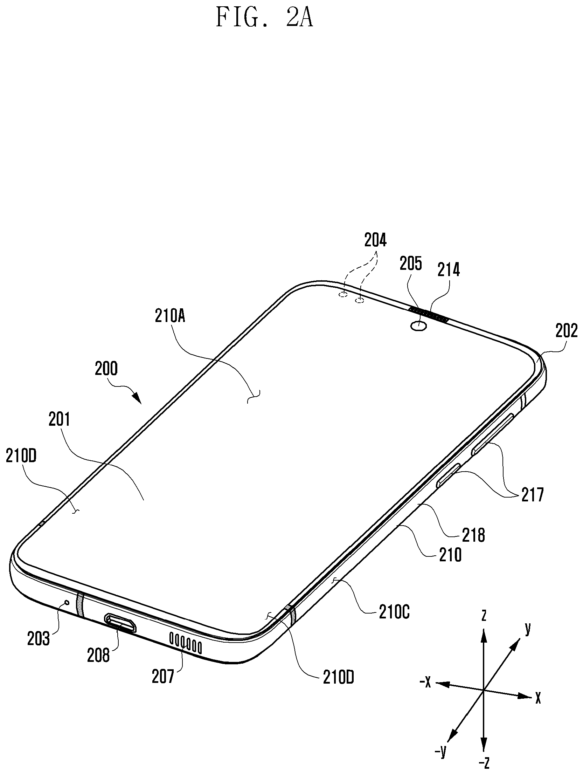

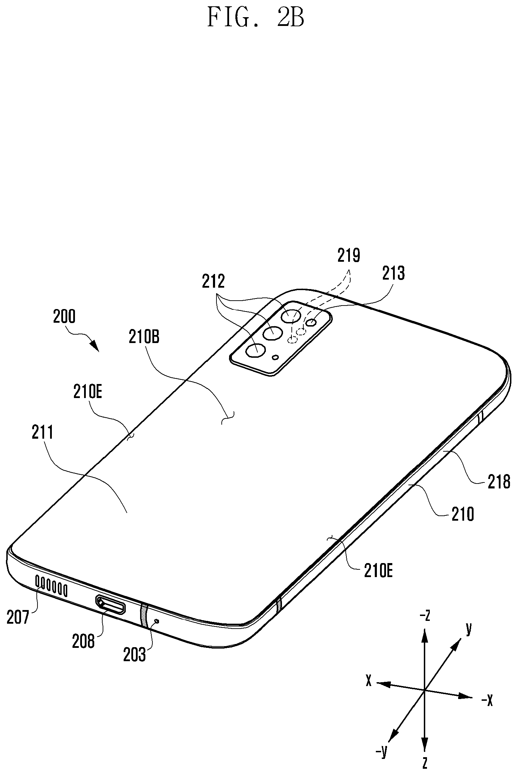

FIG. 2a is a perspective view of the front surface of an electronic device 200 according to an embodiment of the present disclosure. FIG. 2b is a perspective view of the rear surface of the electronic device 200 of FIG. 2a according to an embodiment of the present disclosure.

The electronic device 200 of FIGS. 2a and 2b may be at least partially similar to the electronic device 101 of FIG. 1 or may include other embodiments of the electronic device.

With reference to FIGS. 2a and 2b, the electronic device 200 according to an embodiment may include a housing 210 including the first surface (or the front surface) 210A, the second surface (or the rear surface) 210B, and the side surface 210C surrounding the space between the first surface 210A and the second surface 210B. In an embodiment, the housing 210 may refer to a structure forming a portion of the first surface 210A, the second surface 210B, and the side surface 210C of FIG. 2a. According to an embodiment, the first surface 210A may be formed by at least a partially transparent front plate 202 (e.g., a glass plate or a polymer plate comprising various coating layers). The second surface 210B may be formed by a substantially opaque rear plate 211. The rear plate 211 may be formed, for example, by a coated or colored glass, a ceramic, a polymer, a metal (e.g., an aluminum, a stainless steel (STS), or a magnesium), or a combination of at least two of the above materials. The side surface 210C may be coupled with the front plate 202 and the rear plate 211 and may be formed by a side bezel structure 218 (or the "lateral member") including a metal and/or a polymer. In some embodiments, the rear plate 211 and the side bezel structure 218 may be integrally formed and may contain the same material (e.g., a metal material such as an aluminum).

In the illustrated embodiment, the front plate 202 may include a seamlessly extended first area 210D that is curved from the first surface 210a to the rear plate 211 to include both ends of the long edge of the front plate 202. In the illustrated embodiment (e.g., refer to FIG. 2B), the rear plate 211 may include a second area 210E curved from the second surface 210B to the front plate 202 and extended seamlessly. In some embodiments, the front plate 202 or the rear plate 211 may include only one of the first area 210D or the second area 210E. In some embodiments, the front plate 202 may not include the first area and the second area but may include only a flat plane parallel to the second surface 210B. In the embodiments, when viewed from the side of the electronic device, the side bezel structure 218 may have a first thickness (or width) on the side surface that does not include the first area 210D or the second area 210E as described above, and it may have a second thickness thinner than the first thickness on the side surface that includes the first area 210D or the second area 210E.

According to an embodiment, the electronic device 200 may include at least one of a display 201, an input device 203, a sound output device 207 and 214, a sensor module 204 and 219, a camera module 205 and 212, a key input device 217, an indicator, and a connector 208. In some embodiments, the electronic device 200 may omit at least one of the components (e.g., a key input device 217 or an indicator) or may additionally include other components.

According to an embodiment, the display 201 may be exposed, for example, through a substantial portion of the front plate 202. In some embodiments, at least a portion of the display 201 may be exposed through the first surface 210A and the front plate 202 forming the first area 210D of the side surface 210C. The display 201 may be disposed by being combined with or adjacent to a touch sensing circuit, a pressure sensor capable of measuring the intensity (e.g., the pressure) of the touch, and/or a digitizer detecting a stylus pen of a magnetic field type. In some embodiments, at least a portion of the sensor modules 204 and 219 and/or at least a portion of the key input device 217 may be disposed in the first area 210D and/or the second area 210E.

The input device 203 may include a microphone 203. In some embodiments, the input device 203 may include a plurality of microphones 203 disposed to sense the direction of sound. The sound output devices 207 and 214 may include speakers 207 and 214. The speakers 207 and 214 may include an external speaker 207 and a call receiver 214. In some embodiments, the microphone 203, speakers 207 and 214, and connector 208 may be disposed in the space above the electronic device 200 and may be exposed to the external environment through at least one hole formed in the housing 210. In some embodiments, the holes formed in the housing 210 may be used in common for microphone 203 and speakers 207 and 214. In some embodiments, the sound output devices 207 and 214 may include a speaker (e.g., piezo speaker) operating while excluding the hole formed in the housing 210.

The sensor modules 204 and 219 may generate an electrical signal or data value corresponding to the internal operating state of the electronic device 200 or an external environmental state. The sensor modules 204 and 219 may include, for example, a first sensor module 204 (e.g., a proximity sensor) and/or a second sensor module (e.g., a fingerprint sensor) disposed on the first surface 210A of the housing 210, and/or a third sensor module 219 (e.g., an HRM sensor) disposed on the second surface 210B of the housing 210. The fingerprint sensor may be disposed on the first surface 210A (e.g., a home key button) of the housing 210, a partial area of the second surface 210B, and/or below the display 201. The electronic device 200 may further include a sensor module not shown, such as at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

The camera module 205 and 212 may include a first camera device 205 disposed on the first surface 210A of the electronic device 200, a second camera device 212 disposed on the second surface 210B, and/or a flash 213. The camera module 205 and 212 may include one or a plurality of lenses, an image sensor, and/or an image signal processor. The flash 213 may include, for example, a light-emitting diode or a xenon lamp. In some embodiments, two or more lenses (e.g., wide-angle, ultra wide-angle and telephoto lenses) and image sensors may be disposed on one side of the electronic device 200.

The key input device 217 may be disposed on the side surface 210C of the housing 210. In an embodiment, the electronic device 200 may not include some or all of the above-mentioned key input devices 217, and the unincluded key input device 217 may be implemented in another form, such as a soft key, on the display 201. In an embodiment, the key input device 217 may be implemented using a pressure sensor included in the display 201.

The indicator (not shown) may be disposed, for example, on the first surface 210A of housing 210. The indicator may provide state information of the electronic device 200, for example, in optical form (e.g., an light-emitting element). In an embodiment, the light-emitting element may provide a light source that is interworked, for example, with the operation of the camera module 205. The indicator may include, for example, an LED, an IR LED, and a xenon lamp.

The connector hole 208 may include a first connector hole accommodating a connector (e.g., a universal serial bus (USB) connector) for transmitting and receiving power and/or data to/from an external electronic device and/or a second connector hole (or earphone jack) (not shown) accommodating a connector transmitting and receiving an audio signal to/from the external electronic device.

Some camera modules 205 of the camera modules 205 and 212, some sensor modules 204 of the sensor modules 204 and 219, or indicator may be disposed to be exposed through the display 201. For example, the camera module 205, the sensor module 204, or the indicator may be disposed so that it can be in contact with the external environment through an opening perforated to the front plate 202 or the transmission area of the display in the internal space of the electronic device 200. According to an embodiment, the area facing the display 201 and the camera module 205 may be formed as a transmission area having a certain transmittance as part of the area displaying content. According to an embodiment, the transmission area may be formed to have a transmittance in the range of about 5% ~ 20%. This transmission area may include an area that overlaps with an effective area (e.g., field of view area) of the camera module 205 through which light passes for generating an image using an image sensor. For example, the transmission area of the display 201 may include an area with a lower pixel density than the surrounding area. For example, the transmission area may replace the opening. For example, the camera module 205 may include an under display camera (UDC). In an embodiment, some sensor module 204 may be disposed to perform its function in the internal space of the electronic device 200 without being visually exposed through the front plate 202. For example, in this case, the area facing the sensor module 204 of the display 201 may not require a perforated opening.

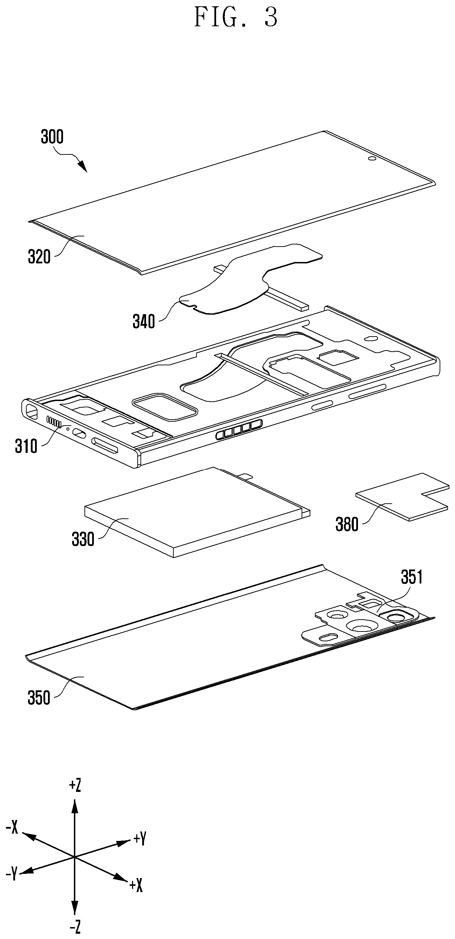

FIG. 3 is an exploded perspective view of an electronic device 300 according to an embodiment of the present disclosure.

The electronic device 300 shown in FIG. 3 may refer to the electronic device 101 of FIG. 1 or may include at least a portion of the electronic device 101 of FIG. 1.

The electronic device 300 shown in FIG. 3 may refer to the electronic device 200 of FIG. 2 or may include at least a portion of the electronic device 200 of FIG. 2.

In describing the electronic device 300 according to an embodiment of the present disclosure, a width direction of the electronic device 300 may mean an x-axis direction, and a length direction of the electronic device 300 may mean a y-axis direction. A height direction of the electronic device 300 may mean a z-axis direction.

The electronic device 300 according to an embodiment of the present disclosure may include a housing 310, a display 320, a battery 330, a thermal diffusion member 340, a rear surface cover 350, and/or a printed circuit board 380.

In an embodiment, the housing 310 may form the exterior of the electronic device 300. With reference to FIG. 3, the housing 310 may include spaces within which different configurations of electronic device 300 may be disposed.

In an embodiment, components of the electronic device 300 may be disposed in the housing 310. For example, a display 320, a battery 330, a thermal diffusion member 340, a rear surface cover 350, and a printed circuit board 380 may be disposed in the housing 310.

In an embodiment, the battery 330 may provide power to at least one component of the electronic device 300.

In an embodiment, the display 320 may be disposed on one surface of the housing 310. The rear surface cover 350 according to an embodiment may be disposed on the other surface, which is the opposite surface of the one surface of the housing 310.

In an embodiment, the rear surface cover 350 may include a deco 351. The deco 351 may be configured to cover at least a portion of the camera module 180 (see FIG. 1).

In an embodiment, the thermal diffusion member 340 may be disposed among the battery 330, the printed circuit board 380, and the display 320. For example, the thermal diffusion member 340 may be disposed in a direction (e.g., a negative z-axis direction) that faces away from the display 320 toward the interior of the electronic device 300.

In an embodiment, the thermal diffusion member 340 may serve to diffuse heat generated by a heat source to other areas. For example, the thermal diffusion member 340 may diffuse heat generated by the printed circuit board 380 to other areas of the electronic device 300. The thermal diffusion member 340 according to an embodiment may have one end in contact with the printed circuit board 380 and the other end in contact with the battery 330.

To improve the thermal diffusion performance of the thermal diffusion member 340, the thermal diffusion member 340 may be extended to have a non-curved plane. For example, the thermal diffusion member 340 may extend so that at least a portion of the thermal diffusion member 340 has a plane substantially perpendicular to the height direction of the electronic device 300. Since the display 320 has a plane substantially perpendicular to the height direction of the electronic device 300, the thermal diffusion member 340 may be disposed on one surface of the display 320 (e.g., a surface facing a negative z-axis direction from the display 320).

In an embodiment, the thermal diffusion member 340 may include a planar shape and may be disposed on one surface of the display 320 extending into the plane. The thermal diffusion member 340 according to an embodiment may include a planar shape, which may make manufacturing of the thermal diffusion member 340 easier.

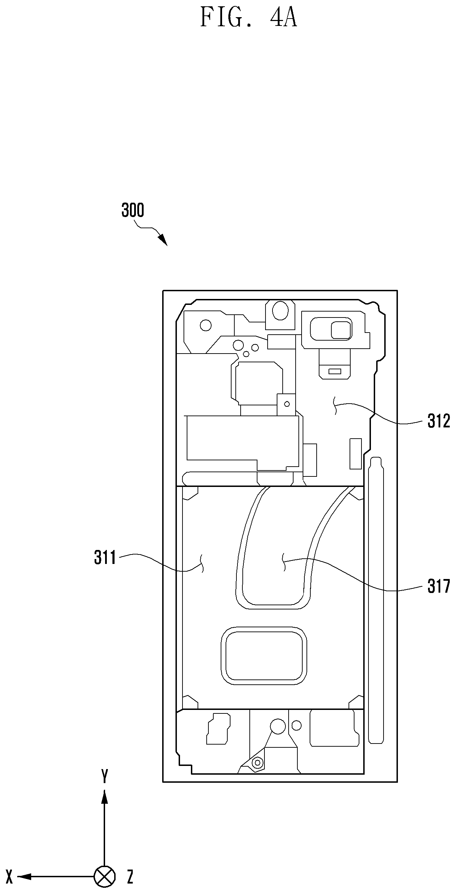

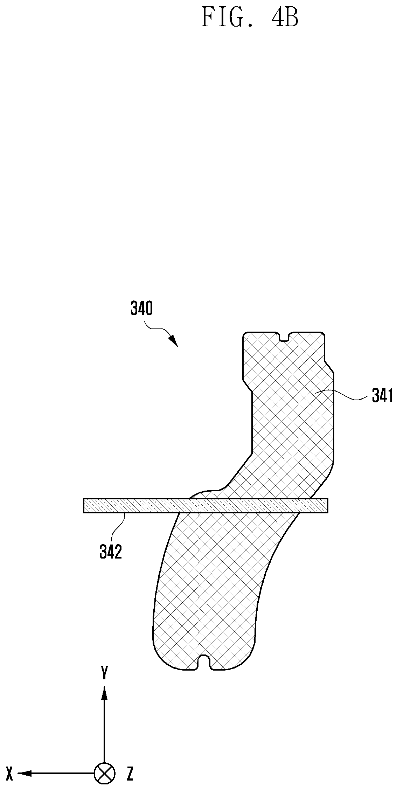

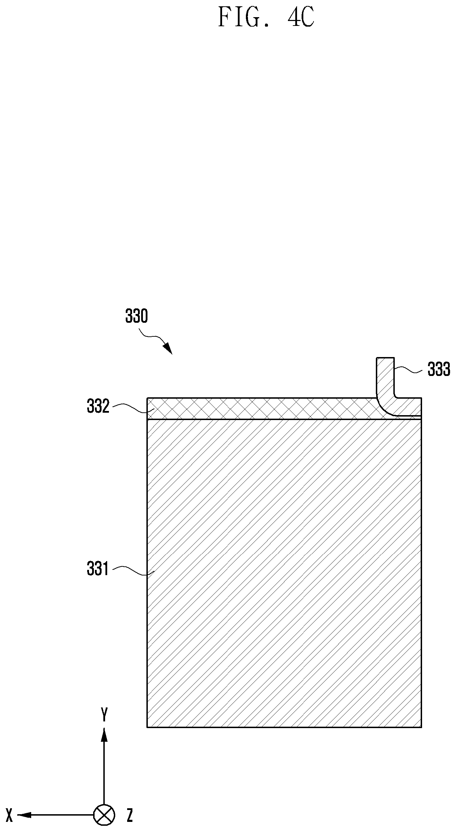

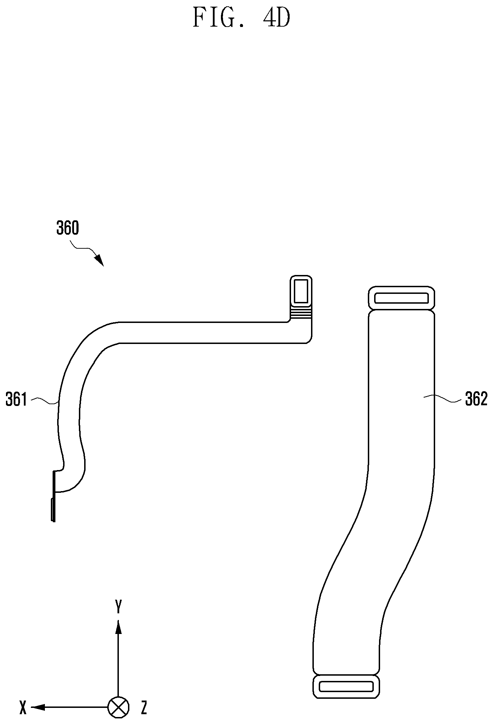

FIGS. 4a, 4b, 4c, and 4d are diagrams illustrating a housing 310, a battery 330, a thermal diffusion member 340, and a flexible printed circuit board 360 according to an embodiment of the present disclosure.

FIG. 4a is a diagram illustrating a housing 310 according to an embodiment. FIG. 4b is a diagram illustrating a thermal diffusion member 340 according to an embodiment. FIG. 4c is a diagram illustrating a battery 330 according to an embodiment. FIG. 4d is a diagram illustrating a flexible printed circuit board 360 according to an embodiment.

With reference to FIG. 4a, the housing 310 according to an embodiment may include a first space 311, a second space 312, and/or a placement space 317. Different configurations of the electronic device 300 may be disposed in the first space 311 and second space 312 of the housing 310.

In an embodiment, the placement space 317 of the housing 310 may be a space in which at least a portion of the thermal diffusion member 340 is seated. The placement space 317 may be formed with a shape corresponding to at least a portion of the thermal diffusion member 340.

With reference to FIG. 4b, the thermal diffusion member 340 according to an embodiment may include a first diffusion area 341 and/or a second diffusion area 342.

In an embodiment, the first diffusion area 341 may extend with a bend in at least a portion. For example, the first diffusion area 341 may extend in the length direction of the electronic device 300 and then bend and extend in at least a portion in the width direction (e.g., the x-axis direction) of the electronic device 300. In an embodiment, the first diffusion area 341 may include a vapor chamber, a heat pipe, and/or a heat sink.

In an embodiment, the second diffusion area 342 may extend in a direction substantially perpendicular to the first diffusion area 341. For example, the second diffusion area 342 may extend along the width direction (e.g., the x-axis direction) of the electronic device 300. In an embodiment, the second diffusion area 342 may include a vapor chamber, a heat pipe, and/or a heat radiation fin.

With reference to FIG. 4c, the battery 330 according to an embodiment may include a first area 331, a second area 332, and/or a connection area 333.

In an embodiment, the first area 331 may be an area where cells of the battery 330 are positioned. The second area 332 may be an area where a protection circuit module (PCM) of the battery 330 is positioned. For example, the second area 332 may be an area where protection elements (e.g., protection ICs, and/or MOSFETs) are disposed to protect the battery 330 by cutting off or reducing overcharge, overdischarge, and/or overcurrent in the battery 330.

In an embodiment, the second area 332 may be disposed at an end of the first area 331. The end of the first area 331 may refer to an end located in the positive y-axis direction of the first area 331. The second area 332 may extend from the end of the first area 331 in a width direction (e.g., an x-axis direction) of the electronic device 300.

In an embodiment, the second diffusion area 342 of the thermal diffusion member 340 may extend along a direction in which the second area 332 of the battery 330 extends. The second diffusion area 342 of the thermal diffusion member 340 may be disposed to be overlapped with at least a portion of the second area 332 of the battery 330. For example, the second diffusion area 342 of the thermal diffusion member 340 may be disposed to be overlapped with at least a portion of a protection element (e.g., a protection IC, and/or a MOSFET) for protecting the battery 330.

In an embodiment, the battery 330 may be electrically connected to the printed circuit board 380 at a connection area 333. The connection area 333 may be an area that extends at least partially in a length direction (e.g., the y-axis direction) relative to the battery 330.

FIG. 4d is a diagram illustrating a flexible printed circuit board 360 according to an embodiment of the present disclosure.

The electronic device 300 according to an embodiment may include at least one flexible printed circuit board 360. The flexible printed circuit board 360 may include a first flexible printed circuit board 361 and/or a second flexible printed circuit board 362.

In an embodiment, the flexible printed circuit boards 360 may serve to electrically connect the printed circuit boards 380 and other components of the electronic device 300. For example, the first flexible printed circuit board 361 may electrically connect an antenna (e.g., the antenna module 197 of FIG. 1) and the printed circuit board 380. The second flexible printed circuit board 362 may electrically connect a display module (e.g., the display module 160 in FIG. 1) and the printed circuit board 380.

In an embodiment, the flexible printed circuit board 360 may extend with a bend in at least a portion. For example, the flexible printed circuit board 360 may extend in a length direction (e.g., a y-axis direction) of the electronic device 300 and then bend in at least a portion and extend in a width direction (e.g., an x-axis direction) of the electronic device 300.

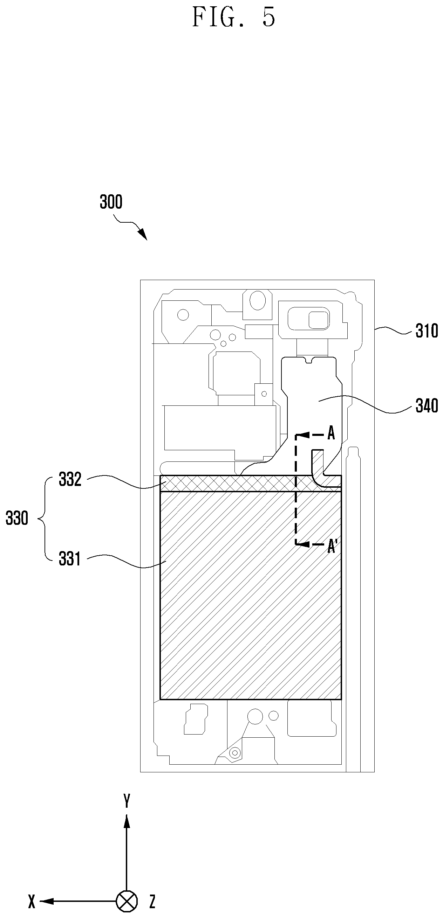

FIG. 5 is a diagram illustrating a battery 330 and a thermal diffusion member 340 disposed in a housing 310 according to an embodiment of the present disclosure.

FIG. 5 may be a diagram illustrating a housing 310, a battery 330, and a thermal diffusion member 340 omitting other configurations in an electronic device 300 according to an embodiment.

With reference to FIG. 5, the battery 330 and thermal diffusion member 340 according to an embodiment may be disposed in the housing 310.

In an embodiment, the thermal diffusion member 340 may be disposed so that at least a portion of the thermal diffusion member 340 is overlapped with the battery 330. For example, the thermal diffusion member 340 may be overlapped with at least a portion of the first area 331 and the second area 332 of the battery 330.

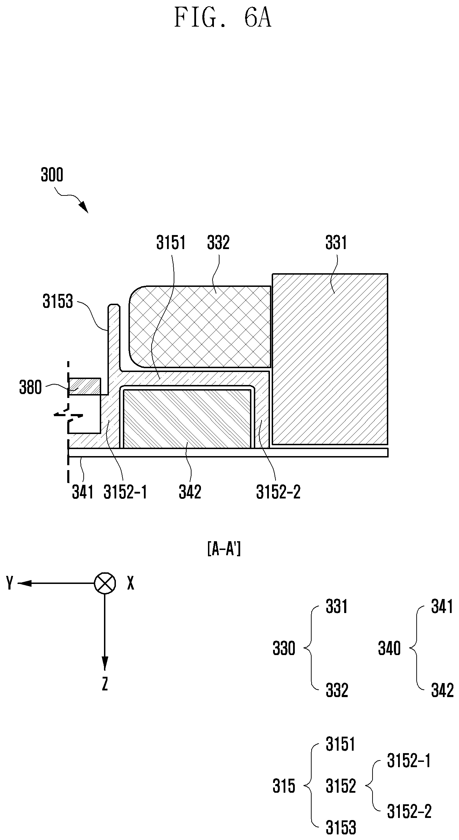

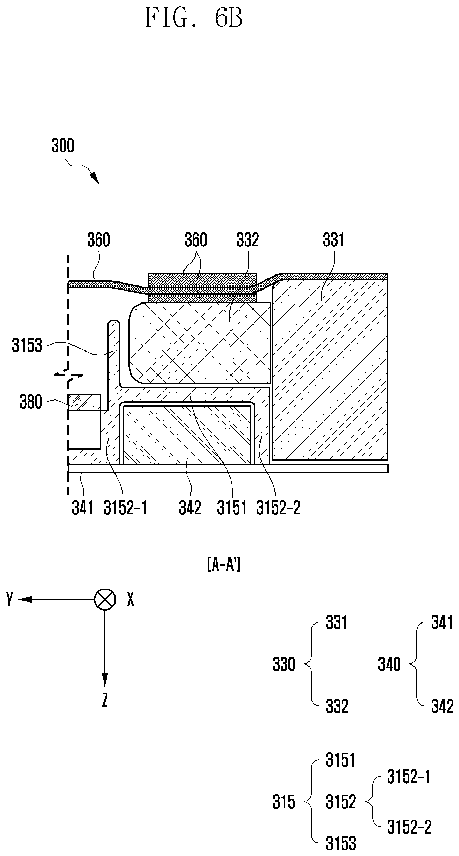

FIGS. 6a and 6b are diagrams illustrating the electronic device 300 as viewed from the A-A' cross-section shown in FIG. 5.

FIG. 6a is a diagram illustrating a battery 330 and a thermal diffusion member 340 according to an embodiment. FIG. 6b is a diagram illustrating a battery 330, a thermal diffusion member 340, and a flexible printed circuit board 360 according to an embodiment.

In an embodiment, a first diffusion area 341 of the thermal diffusion member 340 may extend along a length direction (e.g., a y-axis direction) of the electronic device 300. A second diffusion area 342 and battery 330 may be disposed in one direction (e.g., a negative z-axis direction) of the first diffusion area 341.

In an embodiment, the first diffusion area 341 may extend so that at least a portion is disposed being overlapped with the printed circuit board 380, and at least a portion is disposed in the first area 331 of the battery 330. For example, one end of the first diffusion area 341 may be disposed being overlapped with the printed circuit board 380 and a second end may be disposed in the first area 331 of the battery 330. One end of the first diffusion area 341 may refer to an end located in the positive y-axis direction of the first diffusion area 341, and the other end of the first diffusion area 341 may refer to an end located in the negative y-axis direction of the first diffusion area 341.

In an embodiment, the second diffusion area 342 of the thermal diffusion member 340 may be disposed in a position that is overlapped with the second area 332 of the battery 330. For example, with reference to FIGS. 6a and 6b, the second area 332 of the battery 330 may be disposed in a height direction (e.g., a negative z-axis direction) relative to the second diffusion area 342.

In an embodiment, at least a portion of the battery 330 may have a different thickness than the remainder. The thickness of the battery 330 may refer to the length that the battery 330 extends in the height direction (e.g., the z-axis direction) of the electronic device 300. The thickness of the second area 332 of the battery 330 may be formed to be thinner than the thickness of the first area 331 of the battery 330.

In an embodiment, the second diffusion area 342 may be positioned between the first diffusion area 341 and the second area 332 of the battery 330. The battery 330 may be formed so that the thickness of the second area 332 is thinner than the thickness of the first area 331, thereby providing space for the second diffusion area 342 of the thermal diffusion member 340 to be disposed.

In an embodiment, the printed circuit board 380 may be positioned in one direction of the battery 330. For example, with reference to FIGS. 6a and 6b, the printed circuit board 380 may be positioned in a positive y-axis direction relative to battery 330.

In an embodiment, the housing 310 (see FIG. 4a) may include a support area 315. The support area 315 may be a structure formed by at least a portion of the housing 310 extending to surround the second diffusion area 342. The second diffusion area 342 according to an embodiment may be disposed in the support area 315.

In an embodiment, the support area 315 may include a first support area 3151, a second support area 3152, and/or a third support area 3153. The first support area 3151 may extend in a direction substantially perpendicular to the second support area 3152 and the third support area 3153.

In an embodiment, two second support areas 3152 may be formed. For example, the second support area 3152 may include a second-1 support area 3152-1 and/or a second-2 support area 3152-2. The second-1 support area 3152-1 may extend in a direction substantially perpendicular to the first support area 3151 on one side of the first support area 3151. The second support area 3152-2 may extend in a direction substantially perpendicular to the first support area 3151 on the other side of the first support area 3151.

In an embodiment, the second-1 support area 3152-1 may be positioned in one direction (e.g., a positive y-axis direction) of the second diffusion area 342 and may support the second diffusion area 342. The second-2 support area 3152-2 may be positioned in the other direction (e.g., a negative y-axis direction) of the second diffusion area 342 and may support the second diffusion area 342.

With reference to FIGS. 6a and 6b, the first support area 3151 may be disposed between the second diffusion area 342 and the second area 332 of the battery 330 according to an embodiment. The second support area 3152 may be disposed on one side and the other side of the second diffusion area 342.

In an embodiment, the second diffusion area 342 of the thermal diffusion member 340 may be supported by the first support area 3151 and the second support area 3152 to maintain a predetermined position within the electronic device 300.

In an embodiment, the third support area 3153 may be positioned in one direction of the battery 330. For example, the third support area 3153 may be an extension in the opposite direction of the second support area 3152 and may be positioned in a positive y-axis direction relative to the second area 332 of the battery 330. The third support area 3153 may be disposed to face the second area 332 of the battery 330.

In an embodiment, the battery 330 may be supported by the first support area 3151, the second support area 3152, and the third support area 3153 to maintain a predetermined position within the electronic device 300.

The electronic device 300 according to an embodiment may include at least one flexible printed circuit board 360. The flexible printed circuit board 360 may serve to electrically connect internal components of the electronic device 300. For example, the flexible printed circuit board 360 may electrically connect the battery 330 and the printed circuit board 380.

With reference to FIG. 6b, at least a portion of the flexible printed circuit board 360 according to an embodiment may be disposed in the second area 332 of the battery 330. The battery 330 may be formed such that the second area 332 is thinner than the first area 331 so that there is room for the flexible printed circuit board 360 to be disposed. The flexible printed circuit board 360 may be disposed in a direction opposite to the direction in which the second diffusion area 342 is positioned relative to the second area 332 of the battery 330.

In an embodiment, the electronic device 300 may utilize the second area 332 of the battery 330 as a space where the flexible printed circuit board 360 is disposed. The electronic device 300 according to an embodiment may not require a separate space on the printed circuit board 380 for placement of the flexible printed circuit board 360 because the second area 332 of the battery 330 provides space for the flexible printed circuit board 360 to be disposed. Thus, the electronic device 300 according to an embodiment may be formed by cutting a portion of the printed circuit board 380 (e.g., the space where the flexible printed circuit board 360 is disposed) and extending the battery 330 in a direction facing the printed circuit board 380.

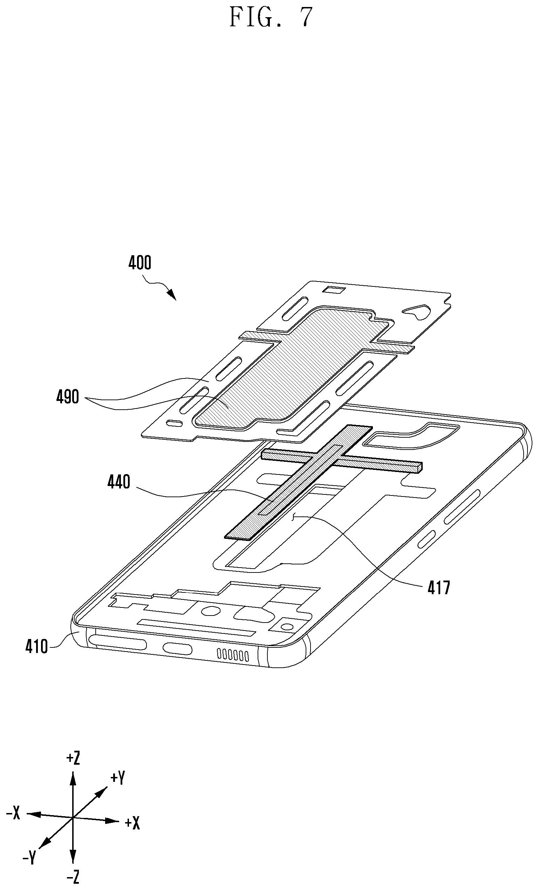

FIG. 7 is an exploded perspective view of an electronic device 400 according to an embodiment of the present disclosure.

The electronic device 400 shown in FIG. 7 may refer to the electronic device 101 of FIG. 1 or may include at least a portion of the electronic device 101 of FIG. 1.

The electronic device 400 shown in FIG. 7 may include at least a portion of the electronic devices 200 and 300 of FIGS. 2 and 3.

In describing the electronic device 400 of FIG. 7, a width direction of the electronic device 400 may mean an x-axis direction, and a length direction of the electronic device 400 may mean a y-axis direction. A height direction of the electronic device 400 may mean a z-axis direction.

The electronic device 400 according to an embodiment of the present disclosure may include a housing 410, a thermal diffusion member 440, and/or a thermal diffusion sheet 490.

In an embodiment, the thermal diffusion member 440 and the thermal diffusion sheet 490 may be disposed in the housing 410.

In an embodiment, the housing 410 may include a placement space 417 in which the thermal diffusion member 440 may be disposed. The placement space 417 may be formed with an opening having a shape corresponding to the shape of the thermal diffusion member 440.

In an embodiment, the thermal diffusion sheet 490 may be disposed to cover one surface of the housing 410 and at least a portion of the thermal diffusion member 440. The thermal diffusion sheet 490 according to an embodiment may include a graphite sheet having heat diffusion capabilities.

In an embodiment, the thermal diffusion sheet 490 may extend along a width direction (e.g., an x-axis direction) and a length direction (e.g., a y-axis direction) of the electronic device 400.

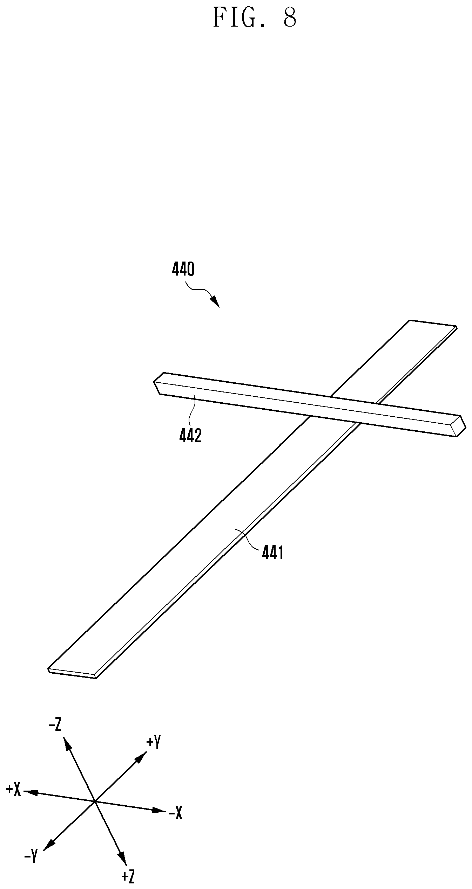

FIG. 8 is a diagram illustrating a thermal diffusion member 440 according to an embodiment of the present disclosure.

In an embodiment, the thermal diffusion member 440 may include a first diffusion area 441 and/or a second diffusion area 442.

In an embodiment, the first diffusion area 441 may extend in a direction substantially perpendicular to the second diffusion area 442. For example, the first diffusion area 441 may extend along a length direction of the electronic device 400 and the second diffusion area 442 may extend along a width direction of the electronic device 400.

In an embodiment, at least a portion of the second diffusion area 442 may be disposed on one surface of the first diffusion area 441. For example, at least a portion of the second diffusion area 442 may be disposed in a direction facing away from the first diffusion area 441 in a negative z-axis direction. The direction in which the second diffusion area 442 is disposed relative to the first diffusion area 441 may be an opposite direction in which the thermal diffusion sheet 490 (see FIG. 7) is disposed.

In an embodiment, the thermal diffusion member 440 may serve to diffuse heat generated by a heat source in the electronic device 400 to other areas of the electronic device 400.

In an embodiment, the first diffusion area 441 and the second diffusion area 442 may be integrally formed. For example, rather than having a second diffusion area 442 formed separately from the first diffusion area 441 and disposed in the first diffusion area 441, the first diffusion area 441 and the second diffusion area 442 may be processed integrally to form the thermal diffusion member 440.

In an embodiment, the first diffusion area 441 may be formed in the shape of a rectangular plate. In an embodiment, the second diffusion area 442 may be formed in a cuboidal bar shape. If the thermal diffusion member 440 is formed in a plate or rod shape, the thermal diffusion member 440 may be easier to manufacture. If the thermal diffusion member 440 is formed in a plate or rod shape, it may be easy to form the first diffusion area 441 and the second diffusion area 442 integrally.

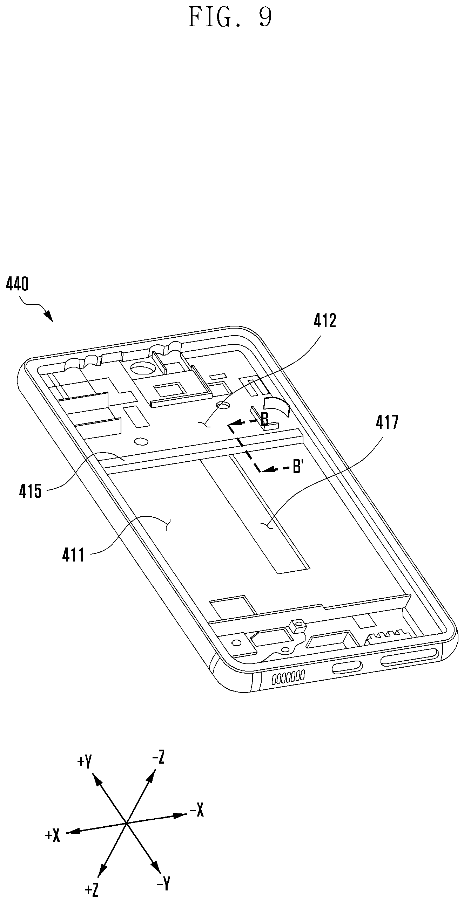

FIG. 9 is a diagram illustrating a housing 410 according to an embodiment of the present disclosure.

The housing 410 according to an embodiment of the present disclosure may include a first space 411, a second space 412, a support area 415, and/or a placement space 417.

In an embodiment, the first space 411 may be a space where the battery 330 (see FIG. 3) is disposed. The second space 412 may be a space where the printed circuit board 380 (see FIG. 3) is disposed.

In an embodiment, the support area 415 may be formed between the first space 411 and the second space 412. For example, the first space 411 and the second space 412 may be separated by the support area 415. The support area 415 may extend along a width direction (e.g., an x-axis direction) of the electronic device 400.

In an embodiment, the housing 410 may increase the rigidity by including a support area 415. The support area 415 may be disposed to support at least a portion of the housing 410 within the housing 410 to improve the rigidity of the housing 410. For example, the housing 410 including the support area 415 may increase the resistance to bending.

In an embodiment, the placement space 417 may be formed at least in part in the first space 411. The placement space 417 may be an opening formed in a shape corresponding to at least a portion of the thermal diffusion member 440. For example, the placement space 417 may be formed in a rectangular opening shape that corresponds to a first diffusion area 441 (see FIG. 8) of the thermal diffusion member 440 (see FIG. 8).

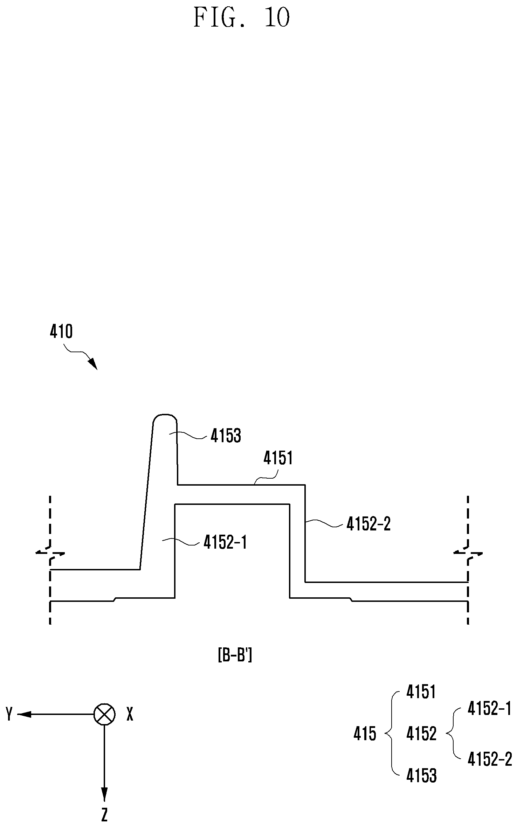

FIG. 10 is a diagram illustrating a support area 415 of a housing 410 according to an embodiment of the present disclosure.

FIG. 10 may be a diagram illustrating a support area 415 of the housing 410 as viewed from the B-B' cross-section shown in FIG. 9.

In an embodiment, the support area 415 may include a first support area 4151, a second support area 4152, and/or a third support area 4153.

In an embodiment, the first support area 4151 may extend in a direction substantially perpendicular to the second support area 4152 and the third support area 4153.

In an embodiment, there may be two second support areas 4152. For example, the second support area 4152 may include a second-1 support area 4152-1 and/or a second-2 support area 4152-2. The second-1 support area 4152-1 may extend in a direction substantially perpendicular to the first support area 4151 on one side of the first support area 4151. The second-2 support area 4152-2 may extend in a direction substantially perpendicular to the first support area 4151 on the other side of the first support area 4151.

In an embodiment, a second diffusion area 442 (see FIG. 8) of the thermal diffusion member 440 (see FIG. 8) may be disposed between the space surrounded by the first support area 4151 and the second support area 4152.

In an embodiment, the second diffusion area 442 (see FIG. 8) of the thermal diffusion member 440 (see FIG. 8) may maintain a predetermined position within the electronic device 400 by being supported by the first support area 4151 and the second support area 4152.

In an embodiment, the first support area 4151 may be disposed between the second diffusion area 442 (see FIG. 8) and the second area 332 (see FIG. 6a) of the battery 330 (see FIG. 6a).

In an embodiment, the third support area 4153 may be positioned in one direction of the battery 330 (see FIG. 6a). For example, the third support area 4153 may be an extension in the opposite direction of the second support area 4152 and may be positioned in a positive y-axis direction relative to the second area 332 (see FIG. 6a) of the battery 330 (see FIG. 6a). The third support area 4153 may be disposed to face the second area 332 (see FIG. 6a) of the battery 330 (see FIG. 6a).

In an embodiment, the battery 330 (see FIG. 6a) may maintain a predetermined position within the electronic device 400 by being supported by a first support area 4151, a second support area 4152, and a third support area 4153.

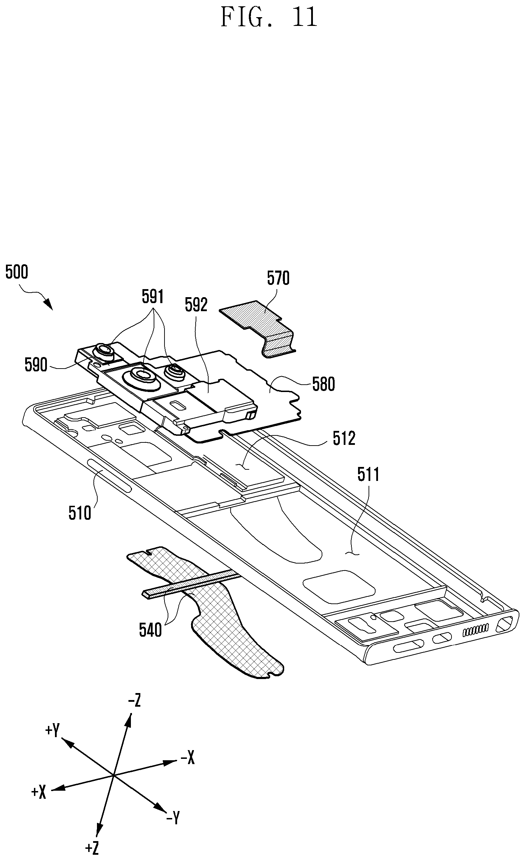

FIG. 11 is an exploded perspective view of an electronic device 500 according to an embodiment of the present disclosure.

The electronic device 500 shown in FIG. 11 may refer to the electronic device 101 of FIG. 1 or may include at least a portion of the electronic device 101 of FIG. 1.

The electronic device 500 shown in FIG. 11 may include at least a portion of the electronic devices 200 and 300 of FIGS. 2 and 3.

In describing the electronic device 500 of FIG. 11, a width direction of the electronic device 500 may mean an x-axis direction, and a length direction of the electronic device 500 may mean a y-axis direction. A height direction of the electronic device 500 may mean a z-axis direction.

An electronic device 500 according to an embodiment of the present disclosure may include a housing 510, a first thermal diffusion member 540, a second thermal diffusion member 570, a printed circuit board 580, and/or a camera module 590.

In an embodiment, the housing 510 may form the exterior of the electronic device 500. With reference to FIG. 3, the housing 510 may include a first space 511 and/or a second space 512 within which different configurations of electronic device 500 may be disposed. The first space 511 may be a space where the battery 330 (see FIG. 3) is disposed. The second space 512 may be a space where the printed circuit board 580 and the camera module 590 are disposed.

In an embodiment, the camera module 590 may include at least one camera 591 and a camera deco 592. The camera deco 592 may be disposed to cover or surround at least a portion of the camera 591.

The thermal diffusion member 540 according to an embodiment shown in FIG. 11 may be substantially the same as the thermal diffusion member 340 shown in FIG. 3. The thermal diffusion member 540 of FIG. 11 may have substantially the same shape and function as the thermal diffusion member 340 of FIG. 3.

In an embodiment, the thermal diffusion member 540 may include a first diffusion area 541 and/or a second diffusion area 542.

In an embodiment, the second thermal diffusion member 570 may extend at least partially in the height direction of the electronic device 500. The second thermal diffusion member 570 may serve to diffuse heat within the electronic device 500 in the height direction of the electronic device 500.

The electronic device 500 according to an embodiment may include a second thermal diffusion member 570, which can diffuse heat inside the electronic device 500 in the height direction of the electronic device 500, thereby improving the thermal diffusion performance of the electronic device 500.

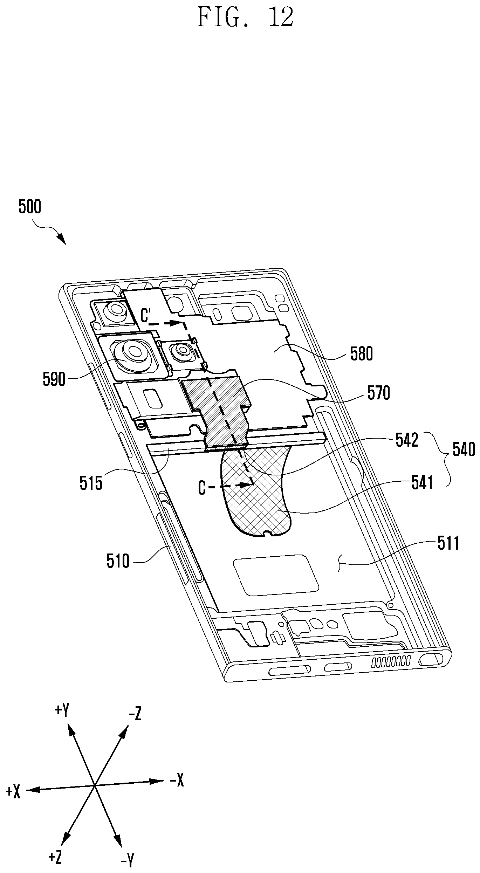

FIG. 12 is a diagram illustrating an electronic device 500 according to an embodiment of the present disclosure.

With reference to FIG. 12, an electronic device 500 according to an embodiment may include a housing 510, a first thermal diffusion member 540, a second thermal diffusion member 570, a printed circuit board 580, and/or a camera module 590.

In an embodiment, the printed circuit board 580 and the camera module 590 may be disposed in the second space 512 of the housing 510. The camera module 590 may be disposed on one side of the printed circuit board 580.

In an embodiment, the housing 510 may include a support area 515. The support area 515 may extend along a width direction (e.g., an x-axis direction) of the electronic device 500 within the housing 510. Bounding the support area 515, a first space 511 and a second space 512 of the housing 510 may be separated.

In an embodiment, the first thermal diffusion member 540 may be at least partially disposed in the support area 515. For example, a second diffusion area 542 of the first thermal diffusion member 540 may be disposed in the support area 515.

In an embodiment, at least a portion of the second thermal diffusion member 570 may be disposed in an opposite direction of the first thermal diffusion member 540 relative to the printed circuit board 580. For example, a portion of the first thermal diffusion member 540 may be disposed in one direction (e.g., a positive z-axis direction) of the printed circuit board 580, and a portion of the second thermal diffusion member 570 may be disposed in the other direction (e.g., a negative z-axis direction) of the printed circuit board 580.

In an embodiment, the second thermal diffusion member 570 may be in contact with the first thermal diffusion member 540 at one end and with the camera module 590 at the other end, which is the opposite end of the one end.

In an embodiment, the second thermal diffusion member 570 may extend at least partially in the height direction of the electronic device 500 and may diffuse heat transferred from the first thermal diffusion member 540 in the height direction of the electronic device 500.

In an embodiment, at least a portion of the support area 515 may be formed in an open configuration. The second diffusion area 542 of the first thermal diffusion member 540 may be in contact with the second thermal diffusion member 570 in the open portion of the support area 515.

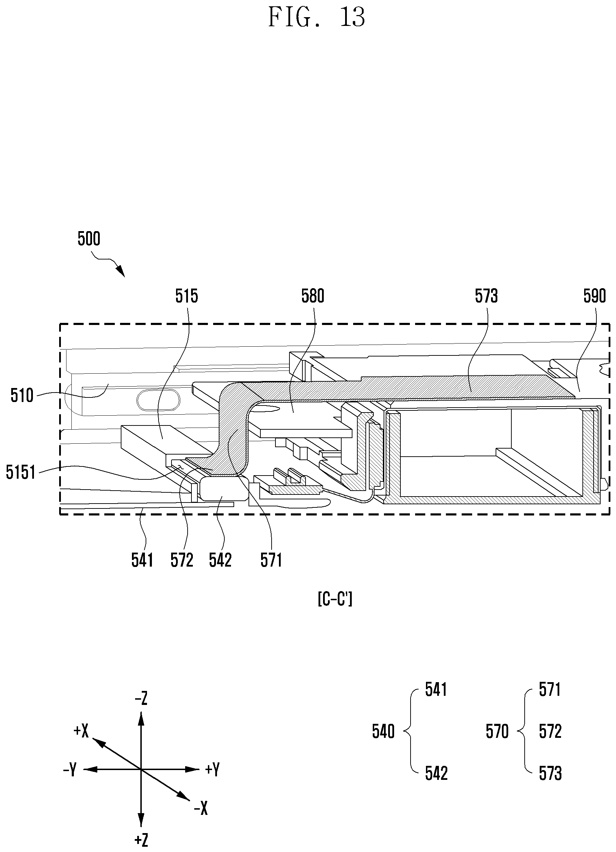

FIG. 13 is a cross-sectional perspective view of electronic device 500 according to an embodiment of the present disclosure.

FIG. 13 may be a cross-sectional perspective view of the electronic device 500 as viewed from the C-C' cross-section of FIG. 12.

In an embodiment, the support area 515 of the housing 510 may include a diffusion opening 5151 through which a portion of the support area 515 is open. At the diffusion opening 5151, a second diffusion area 542 of the first thermal diffusion member 540 may be exposed.

In an embodiment, the second thermal diffusion member 570 may include an extension area 571, a first contact area 572, and/or a second contact area 573.

In an embodiment, the first contact area 572 of the second thermal diffusion member 570 may be in contact with the first thermal diffusion member 540. For example, the first contact area 572 may be in contact with the second diffusion area 542 of the first thermal diffusion member 540 located at the diffusion opening 5151.

In an embodiment, the extension area 571 may extend in a height direction (e.g., a z-axis direction) of the electronic device 500. The extension area 571 may connect with the first contact area 572 at one end and with the second contact area 573 at the other end.

In an embodiment, a second contact area 573 of the second thermal diffusion member 570 may be in contact with the camera module 590. The second thermal diffusion member 570 may diffuse heat transferred from the first thermal diffusion member 540 in the direction in which the camera module 590 is located.

With reference to FIG. 13, a second contact area 573 of the second thermal diffusion member 570 according to an embodiment is shown to be disposed on the camera module 590, but this is exemplary and the location where the second contact area 573 is disposed may not be limited thereto. The second contact area 573 may also be disposed to contact other configurations of the electronic device 500 than the camera module 590.

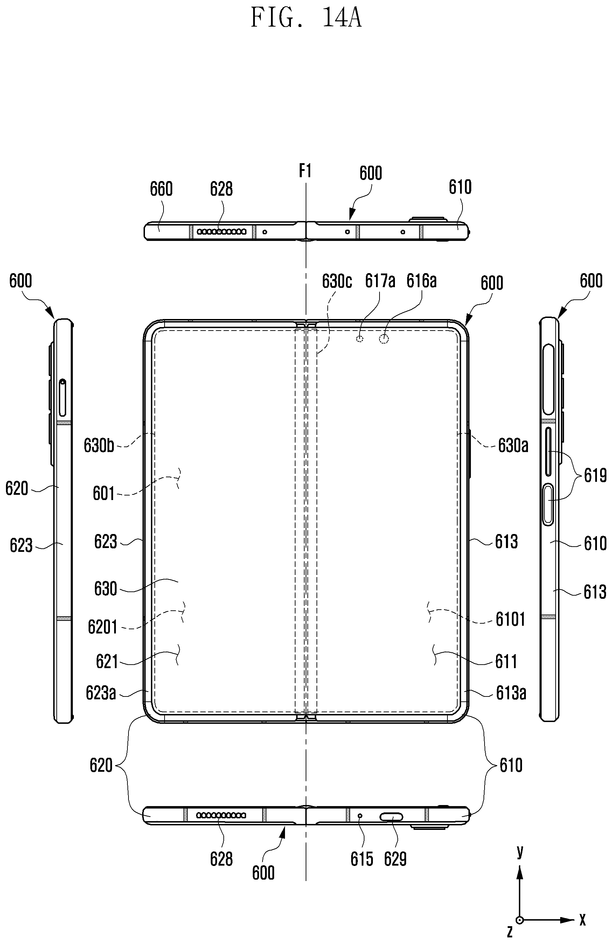

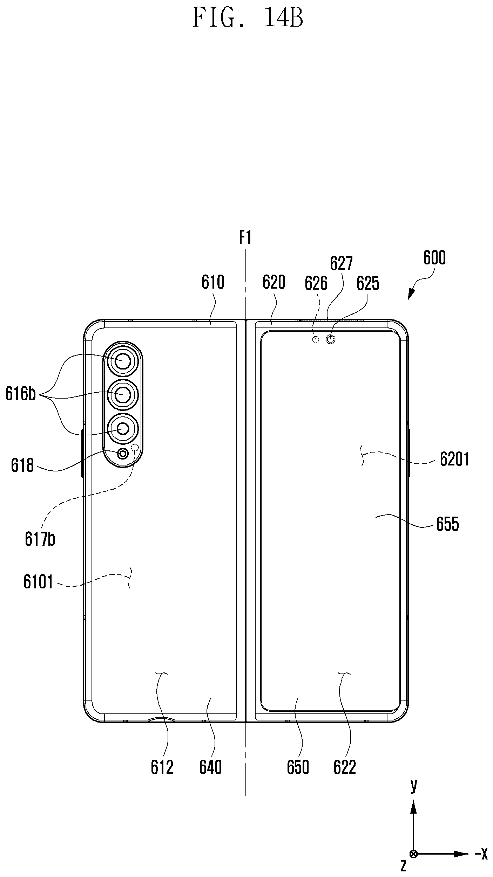

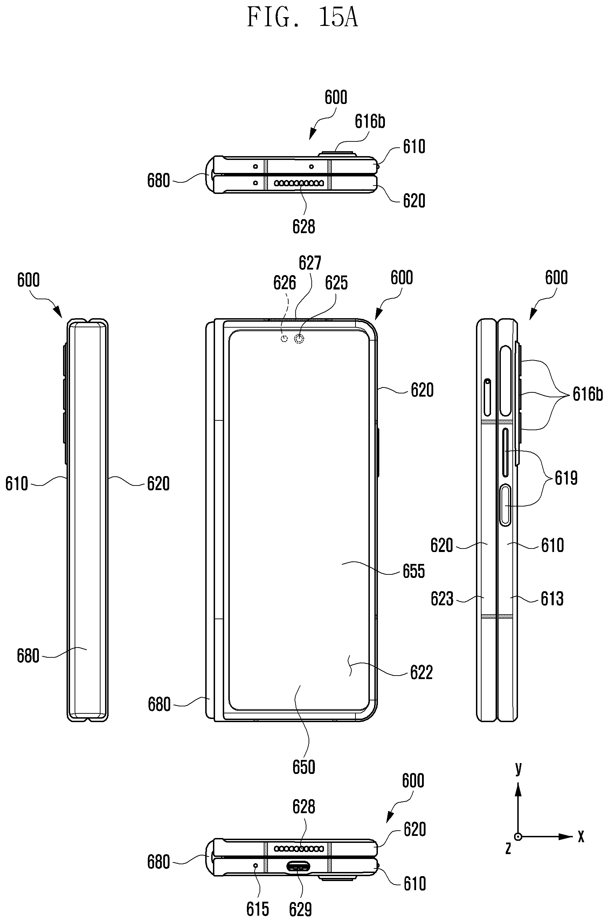

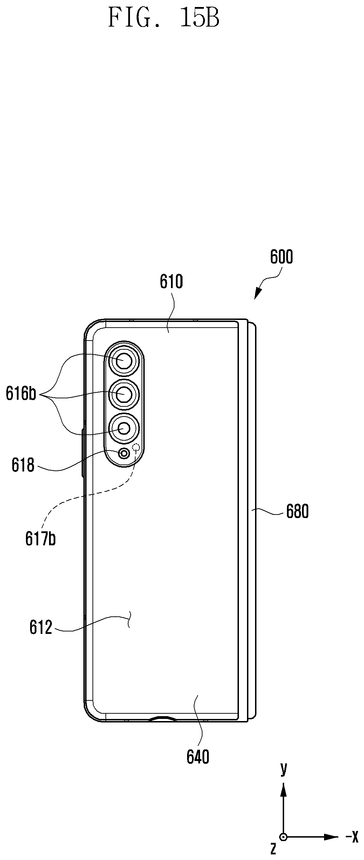

FIGS. 14A and 14B are diagrams illustrating a front view and a rear view, respectively, of an unfolded state of an electronic device according to an embodiment. FIGS. 15A and 15B are diagrams illustrating a front view and a rear view, respectively, of a folded state of an electronic device according to an embodiment.

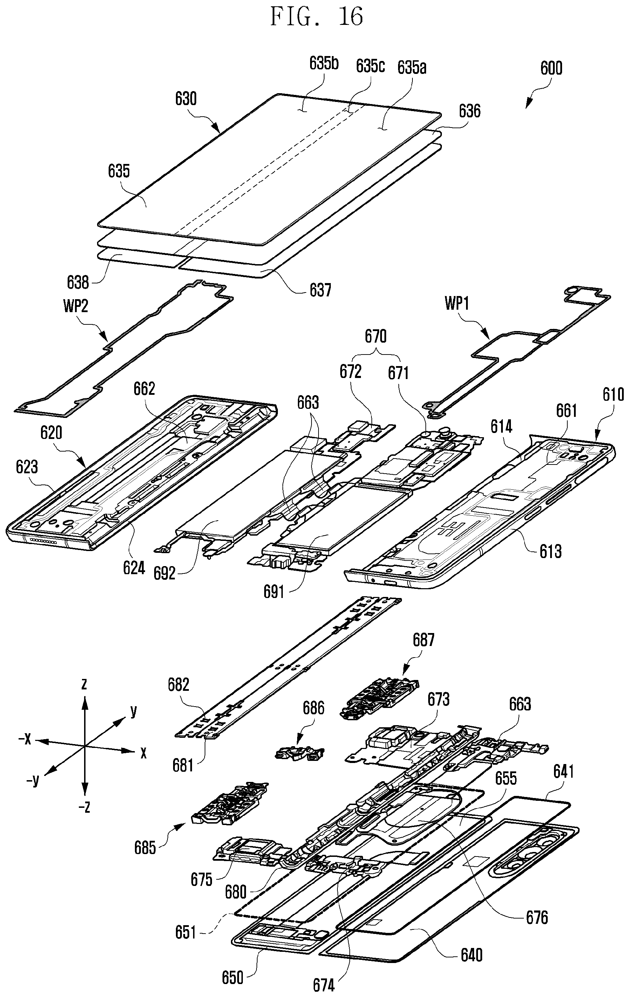

Referring to FIGS. 14A, 14B, 15A and 15B (which may be referred to as FIGS. 14A to 15B), an electronic device 600 may include a pair of housings 610 and 620 (e.g., a foldable housing structure) rotatably coupled to each other with reference to folding axis F1 through a hinge device (e.g., a hinge device 685 and 687 of FIG. 16) (e.g., a hinge module) so as to be folded with respect to each other, a first display 630 (e.g., a flexible display, a foldable display, or a main display) disposed through the pair of housings 610 and 620, and/or a second display 655 (e.g., a sub display) disposed through the second housing 620. According to an embodiment, at least a part of the hinge device (e.g., the hinge device 685 and 687 of FIG. 16) may be disposed so as not to be seen from the outside through the first housing 610 and the second housing 620, and may be disposed so as not to be seen from the outside through the hinge housing 680 covering a foldable portion. According to an embodiment, the hinge device may include a hinge module including a gear assembly including multiple gears and multiple hinge cams which are coupled to hinge shafts rotating through the gear assembly and perform a cam interlocking operation, and hinge plates for connecting the hinge model to the first housing 610 and the second housing 620. In the disclosure, a surface in which the first display 630 is disposed may be defined as a front surface of the electronic device 600, and a surface opposite to the front surface may be defined as a rear surface of the electronic device 600. In addition, a surface surrounding a space between the front surface and the rear surface may be defined as a side surface of the electronic device 600.

According to an embodiment, the pair of housings 610 and 620 may include a first housing 610 and a second housing 620 foldably arranged with respect to each other through the hinge device (e.g., the hinge device 685 and 687 of FIG. 16). According to an embodiment, the shape and the coupling of the pair of housings 610 and 620 are not limited to those illustrated in FIGS. 14A to 15B, and the pair of housings 610 and 620 may be implemented by a combination and/or coupling of other shapes or components. According to an embodiment, the first housing 610 and the second housing 620 may be arranged on opposite sides with reference to the folding axis F1, and may have shapes that are entirely symmetric to each other with respect to the folding axis F1. According to an embodiment, the first housing 610 and the second housing 620 may be asymmetrically folded with reference to the folding axis F1. According to an embodiment, the angle or the distance between the first housing 610 and the second housing 620 may vary depending on whether the electronic device 600 is in an unfolded state, a folded state, or an intermediate state.

According to an embodiment, the first housing 610 may include, in the unfolded state of the electronic device 600, a first surface 611 connected to the hinge device (e.g., the hinge device 685 and 687 of FIG. 16) and disposed to be oriented to the front surface of the electronic device 600, a second surface 612 oriented in a direction opposite to the first surface 611, and/or a first side member 613 surrounding at least a part of a first space between the first surface 611 and the second surface 612. According to an embodiment, the second housing 620 may include, in the unfolded state of the electronic device 600, a third surface 621 connected to the hinge device (e.g., the hinge device 685 and 687 of FIG. 16) and disposed to be oriented to the front surface of the electronic device 600, a fourth surface 622 oriented in a direction opposite to the third surface 621, and/or a second side member 623 surrounding at least a part of a second space between the third surface 621 and the fourth surface 622. According to an embodiment, the first surface 611 and the third surface 621 may be oriented in substantially the same direction in the unfolded state, and the first surface 611 and the third surface 621 may at least partially face each other in the folded state. According to an embodiment, the electronic device 600 may include a recess 601 formed to receive the first display 630 through structural coupling of the first housing 610 and the second housing 620. According to an embodiment, the recess 601 may have substantially the same shape as the first display 630. According to an embodiment, the first housing 610 may include a first protection frame 613a (e.g., a first decoration member) which is, when seen from above the first display 630, coupled to the first side member 613, disposed to overlap with an edge of the first display 630, so as to cover the edge of the first display 630 to allow the same not to be seen from the outside. According to an embodiment, the first protection frame 613a may be integrally formed with the first side member 613. According to an embodiment, the second housing 620 may include a second protection frame 623a (e.g., a second decoration member) which is, when seen from above the first display 630, coupled to the second side member 623, disposed to overlap with an edge of the first display 630, so as to cover the edge of the first display 630 to allow the same not to be seen from the outside. According to an embodiment, the second protection frame 623a may be integrally formed with the first side member 623. In an embodiment, the first protection frame 613a and the second protection frame 623a may be omitted.

According to an embodiment, the hinge housing 680 (e.g., a hinge cover) may be disposed between the first housing 610 and the second housing 620, and may be disposed to cover a part (e.g., at least one hinge module) of the hinge device (e.g., the hinge device 685 and 687 of FIG. 16) disposed on the hinge housing 680. According to an embodiment, the hinge housing 680 may be hidden or exposed from or to the outside by a part of the first housing 610 and the second housing 620 according to the unfolded state, the folded state, or the intermediate state of the electronic device 600. For example, when the electronic device 600 is in the unfolded state, at least a part of the hinge housing 680 may be covered by the first housing 610 and the second housing 620 and not be substantially exposed. According to an embodiment, when the electronic device 600 is in the folded state, at least a part of the hinge housing 680 may be exposed to the outside between the first housing 610 and the second housing 620. According to an embodiment, in the intermediate state in which the first housing 610 and the second housing 620 are folded with each other by a predetermined angle (folded with a certain angle), the hinge housing 680 may be at least partially exposed to the outside of the electronic device 600 between the first housing 610 and the second housing 620. For example, an area in which the hinge housing 680 is exposed to the outside, may be smaller than that in a case in which the electronic device 600 is completely folded. According to an embodiment, the hinge housing 680 may include a curved surface.

According to an embodiment, when the electronic device 600 is in the unfolded state (e.g., the states shown in FIGS. 14A and 14B), the first housing 610 and the second housing 620 may meet at an about 180-degree angle, and a first area 630a, a second area 630b, and a folding area 630c of the first display 630 may form the same plane and arranged to be oriented in substantially the same direction (e.g., a z-axis direction). In an embodiment, when the electronic device 600 is in the unfolded state, the first housing 610 may rotate by an about 360-degree angle with respect to the second housing 620, and may be outwardly folded (an out-folding scheme) so that the second surface 612 and the fourth surface 622 face each other.

According to an embodiment, when the electronic device 600 is in the folded state (e.g., the states shown in FIGS. 15A and 15B), the first surface 611 of the first housing 610 and the third surface 621 of the second housing 620 may be arranged to face each other. In this case, the first area 630a and the second area 630b of the first display 630 may form a narrow angle (e.g., a range between 0 degrees to about 10 degrees) through the folding area 630c, and may be arranged to face each other. According to an embodiment, at least a part of the folding area 630c may be deformed into a curved shape having a predetermined curvature. According to an embodiment, when the electronic device 600 is in the intermediate state, the first housing 610 and the second housing 620 may be arranged at a predetermined angle (a certain angle). In this case, the first area 630a and the second area 630b of the first display 630 may form an angle that is greater than that in the folded state and smaller than that in the unfolded state, and the curvature of the folding area 630c may be lower than that in the folded state, and may be higher than that in the unfolded state. In an embodiment, the first housing 610 and the second housing 620 may form an angle which allows stopping at a designated folding angle between the folded state and the unfolded state (a free stop function), through the hinge device (e.g., the hinge device 685 and 687 of FIG. 16). In an embodiment, the first housing 610 and the second housing 620 may continuously operate while being pressed in an unfolding direction or a folding direction with reference to a designated inflection angle, through the hinge device (e.g., the hinge device 685 and 687 of FIG. 16).

According to an embodiment, the electronic device 600 may include at least one of at least one display 630 and 655 disposed on the first housing 610 and/or the second housing 620, an input device 615, sound output devices 627 and 628, sensor modules 617a, 617b, and 626, camera modules 616a, 616b, and 625, a key input device 619, an indicator (not shown), or a connector port 629. In an embodiment, the electronic device 600 may omit at least one of the elements, or may additionally include at least one another element.

According to an embodiment, the at least one display 630 and 655 may include a first display 630 (e.g., a flexible display) disposed to be supported by the third surface 621 of the second housing 620 from the first surface 611 of the first housing 610 through the hinge device (e.g., the hinge device 685 and 687 of FIG. 16), and a second display 655 disposed to be at least partially seen from the outside through the fourth surface 622 in a space in the second housing 620. In an embodiment, the second display 655 may be disposed to be seen from the outside through the second surface 612 in a space in the first housing 610. According to an embodiment, the first display 630 may be mainly used in the unfolded state of the electronic device 600, and the second display 655 may be mainly used in the folded state of the electronic device 600. According to an embodiment, the electronic device 600 may control, in the intermediate state, the first display 630 and/or the second display 655 to be used, based on a folding angle between the first housing 610 and the second housing 620.

According to an embodiment, the first display 630 may be disposed in a receiving space formed by the pair of housings 610 and 620. For example, the first display 630 may be disposed in a recess 601 formed by the pair of housings 610 and 620, and may be disposed to occupy substantially the most of the front surface of the electronic device 600 in the unfolded state. According to an embodiment, the first display 630 may include a flexible display having at least one area which can be deformed into a plane or a curved surface. According to an embodiment, the first display 630 may include the first area 630a facing the first housing 610 and the second area 630b facing the second housing 620. According to an embodiment, the first display 630 may include the folding area 630c including a part of the first area 630a and a part of the second area 630b with respect to the folding axis F1. According to an embodiment, at least a part of the folding area 630c may include an area corresponding to the hinge device (e.g., the hinge device 685 and 687 of FIG. 16). According to an embodiment, a division of an area of the first display 630 merely corresponds to an example physical division by the pair of housings 610 and 620 and the hinge device (e.g., the hinge device 685 and 687 of FIG. 16), and the first display 630 may be substantially displayed as one seamless full screen through the pair of the housings 610 and 620 and the hinge device (e.g., the hinge device 685 and 687 of FIG. 16). According to an embodiment, the first area 630a and the second area 630b may have shapes that are entirely symmetric or partially asymmetric to each other with respect to the folding area 630c.

According to an embodiment, the electronic device 600 may include a first rear cover 640 disposed on the second surface 612 of the first housing 610 and a second rear cover 650 disposed on the fourth surface 622 of the second housing 620. In an embodiment, at least a part of the first rear cover 640 may be integrally formed with the first side member 613. In an embodiment, at least a part of the second rear cover 650 may be integrally formed with the second side member 623. According to an embodiment, at least one of the first rear cover 640 and the second rear cover 650 may be substantially formed of a transparent plate (e.g., a polymer plate or glass plate including various coding layers) or an opaque plate. According to an embodiment, the first rear cover 640 may be formed of, for example, an opaque plate such as coded or colored glass, ceramic, polymer, metal (e.g., aluminum, stainless steel (STS), or magnesium), or a combination of at least two of the materials above. According to an embodiment, the second rear cover 650 may be substantially formed of, for example, a transparent plate such as glass or polymer. Accordingly, the second display 655 may be disposed to be seen from the outside through the second rear cover 650 in a space in the second housing 620.

According to an embodiment, the input device 615 may include a microphone. In an embodiment, the input device 615 may include multiple microphones arranged to detect the direction of sound. According to an embodiment, the sound output devices 627 and 628 may include speakers. According to an embodiment, the sound output devices 627 and 628 may include a call receiver 627 disposed through the fourth surface 622 of the second housing 620 and an external speaker 628 disposed through at least a part of the second side member 623 of the second housing 620. In an embodiment, the input device 615, the sound output devices 627 and 628, and the connector 629 may be disposed in spaces of the first housing 610 and/or the second housing 620, and may be exposed to an external environment through at least one hole formed through the first housing 610 and/or the second housing 620. In an embodiment, holes formed through the first housing 610 and/or the second housing 620 may be commonly used for the input device 615 and the sound output devices 627 and 628. In an embodiment, the sound output devices 627 and 628 may include a speaker (e.g., a piezo speaker) operating without including a hole formed through the first housing 610 and/or the second housing 620.

According to an embodiment, the camera modules 616a, 616b, and 625 may include a first camera module 616a disposed on the first surface 611 of the first housing 610, a second camera module 616b disposed on the second surface 612 of the first housing 610, and/or a third camera module 625 disposed on the fourth surface 622 of the second housing 620. According to an embodiment, the electronic device 600 may include a flash 618 disposed around the second camera module 616b. According to an embodiment, the flash 618 may include, for example, a light-emitting diode or a xenon lamp. According to an embodiment, the camera modules 616a, 616b, and 625 may include one or multiple lenses, an image sensor, and/or an image signal processor. In an embodiment, at least one of the camera modules 616a, 616b, and 625 may include two or more lenses (e.g., wide-angle and telephoto lenses) and image sensors, and may be arranged together on one surface of the first housing 610 and/or the second housing 620.

According to an embodiment, the sensor modules 617a, 617b, and 626 may generate a data value or an electrical signal corresponding to an internal operational state or an external environmental state of the electronic device 600.According to an embodiment, the sensor modules 617a, 617b, and 626 may include a first sensor module 617a disposed on the first surface 611 of the first housing 610, a second sensor module 617b disposed on the second surface 612 of the first housing 610, and/or a third sensor module 626 disposed on the fourth surface 622 of the second housing 620. In an embodiment, the sensor modules 617a, 617b, and 626 may include at least one of a gesture sensor, a grip sensor, a color sensor, an infrared (IR) sensor, an illuminance sensor, an ultrasonic sensor, an iris recognition sensor, or a distance detection sensor (e.g., a time of flight (TOF) sensor or a light detection and ranging (LiDAR)).

According to an embodiment, the electronic device 600 may further include an unillustrated sensor module, for example, at least one of an atmospheric sensor, a magnetic sensor, a biometric sensor, a temperature sensor, a humidity sensor, or a fingerprint recognition sensor. In an embodiment, the fingerprint recognition sensor may be disposed through at least one of the first side member 613 of the first housing 610 and/or the second side member 623 of the second housing 620.

According to an embodiment, the key input device 619 may be disposed to be exposed to the outside through the first side member 613 of the first housing 610. In an embodiment, the key input device 619 may be disposed to be exposed to the outside through the second side member 623 of the second housing 620. In an embodiment, the electronic device 600 may not include some or all of the key input device 619, and the unincluded key input device 619 may be implemented in another shape such as a soft key on the least one display 630 and 655. In an embodiment, the key input device 619 may be implemented using a pressure sensor included in the at least one display 630 and 655.

According to an embodiment, the connector port 629 may include a connector (e.g., a USB connector or an IF module (an interface connector port module)) for transmitting or receiving data and/or power to and/or from an external electronic device. In an embodiment, the connector port 629 may perform a function of transmitting or receiving an audio signal to or from the external electronic device together, or may further include a separate connector port (e.g., an ear jack hole) for performing a function of transmitting or receiving an audio signal to or from the external electronic device.

According to an embodiment, at least one camera modules 616a and 625 of the camera modules 616a, 616b, and 625, at least one sensor module 617a and 626 of the sensor modules 617a, 617b, and 626, and/or an indicator may be arranged to be exposed through the at least one display 630 and 655. For example, the at least one camera modules 616a and 625, the at least one sensor module 617a and 626, and/or the indicator may be arranged under an activated area (a display area) of the at least one display 630 and 655 in a space in the at least one housing 610 and 620, and may be arranged to come into contact with an external environment through a transparent area or an opening that is perforated to a cover member (e.g., a window layer (not shown) of the first display 630 and/or the second rear cover 650). According to an embodiment, an area in which the at least one display 630 and 655 and the at least one camera module 616a and 625 face each other may be formed as a transmission area having a predetermined transmission ratio, as a part of an area in which a content is displayed. According to an embodiment, the transmission area may be formed to have a transmission ratio in the range of about 5% to about 20%. The transmission area may include an area overlapping with an effective area (e.g., an angle of view area) of the at least one camera module 616a and 625, wherein an image is formed on the image sensor in the effective area, and light for generating an image passes through the effective area. For example, the transmission area of the display 630 and 655 may include an area in which the density of a pixel is lower than that in a surrounding area. For example, the transmission area may be replaced with an opening. For example, the at least one camera module 616a and 625 may include an under-display camera (UDC) or an under-panel camera (UPC). In an embodiment, some camera modules or sensor modules 617a and 626 may be arranged to perform functions thereof without being visually exposed through the display. For example, an area facing the sensor module 617a and 626 and/or the camera module 616a and 625 arranged under the display 630 and 655 (e.g., a display panel) corresponds to an under-display camera (UDC) structure, and a perforated opening is not necessarily required.

FIG. 16 is an exploded perspective view of the electronic device 600 according to an embodiment of the disclosure.

Referring to FIG. 16, the electronic device 600 may include a first display 630 (e.g., a flexible display), a second display 655, at least one hinge device 685 and 687, and a pair of support members 661 and 662, at least one substrate 670 (e.g., a printed circuit board (PCB)), a first housing 610, a second housing 620, a first rear cover 640, and/or a second rear cover 650.

According to an embodiment, the first display 630 may include a display panel 635 (e.g., a flexible display panel) and a support plate 636 disposed under the display panel 635. According to an embodiment, the first display 630 may include a pair of reinforcing plates 637 and 638 disposed under the supporting plate 636. In some embodiments, the pair of reinforcing plates 637 and 638 may be omitted. According to an embodiment, the display panel 635 may include a first panel area 635a corresponding to a first area (e.g., the first area 630a in FIG. 14A) of the first display 630, a second panel area 635b extending from the first panel area 635a and corresponding to a second area (e.g., the second area 630b in FIG. 14A ) of the first display 630, and a third panel area 635c connecting the first panel area 635a and the second panel area 635b and corresponding to a folding area (e.g., the folding area 630c in FIG. 14A) of the first display 630. According to an embodiment, the support plate 636 may be disposed between the display panel 635 and the pair of support members 661 and 662 and may be formed to have a material and shape for providing a planar support structure for the first panel area 635a and the second panel area 635b. and for providing a bendable structure for advantageously providing the flexibility to the third panel area 635c. According to an embodiment, the support plate 636 may be formed of a conductive material (e.g., metal) or a non-conductive material (e.g., a polymer or fiber reinforced plastic (FRP)). According to an embodiment, the pair of reinforcing plates 637 and 638 may be disposed between the support plate 636 and the pair of support members 661 and 662 and may include the first reinforcing plate 637 disposed to correspond to at least a part of the first panel area 635a and third area 635c, and the second reinforcing plate 638 disposed to correspond to at least a part of the second panel area 635b and the third panel area 635c. According to an embodiment, the pair of reinforcing plates 637 and 638 may be formed of a metal material (e.g., SUS) to advantageously reinforce a ground connection structure and rigidity for the first display 630.

According to an embodiment, the second display 655 may be disposed in a space between the second housing 620 and the second rear cover 650. According to an embodiment, the second display 655 may be visible from the outside through substantially the entire area of the second rear cover 650 while being in the space between the second housing 620 and the second rear cover 650.

According to an embodiment, at least a part of the first support member 661 may be foldably coupled to the second support member 662 through at least one hinge device 685 and 687. According to one embodiment, the electronic device 600 may include at least one wiring member 663 (e.g., a flexible printed circuit board (FPCB)) disposed from at least a part of the first support member 661 to a part of the second support member 662 across the at least one hinge device 685 and 687. According to an embodiment, the first support member 661 may extend from the first lateral member 613 or may be structurally combined with the first lateral member 613. According to an embodiment, the electronic device 600 may include a first space (e.g., the first space 6101 in FIG. 14A) provided through the first support member 661 and the first rear cover 640. According to an embodiment, the first housing 610 (e.g., the first housing structure) may be configured through a combination of the first lateral member 613, the first support member 661, and the first rear cover 640. According to an embodiment, the second support member 662 may extend from the second lateral member 623 or may be structurally combined with the second lateral member 623. According to an embodiment, the electronic device 600 may include a second space (e.g., the second space 6201 in FIG. 14A) provided through the second support member 662 and the second rear cover 650. According to an embodiment, the second housing 620 (e.g., the second housing structure) may be configured through a combination of the second lateral member 623, the second support member 662, and the second rear cover 650. According to an embodiment, at least a part of the at least one wiring member 663 and/or at least one hinge device 685 and 687 may be disposed to be supported through at least a part of the pair of support members 661 and 662. According to an embodiment, at least one wiring member 663 may be disposed in a direction (e.g., the x-axis direction) crossing the first support member 661 and the second support member 662. According to an embodiment, the at least one wiring member 663 may be arranged to have a length in a direction (e.g., the x-axis direction) substantially perpendicular to a folding axis (e.g., the y-axis or the folding axis F1 in FIG. 14A).

According to an embodiment, the at least one substrate 670 may include a first substrate 671 disposed in the first space 6101 and a second substrate 672 disposed in the second space 6201. According to an embodiment, the first substrate 671 and the second substrate 672 may include a plurality of electronic components arranged to implement various functions of the electronic device 600. According to an embodiment, the first substrate 671 and the second substrate 672 may be electrically connected through at least one wiring member 663.

According to an embodiment, the electronic device 600 may include at least one battery 691 and 692. According to an embodiment, the at least one battery 691 and 692 may include a first battery 691 disposed in the first space 6101 of the first housing 610 and electrically connected to the first substrate 671, and a second battery disposed in the second space 6201 of the second housing 620 and electrically connected to the second substrate 672. According to an embodiment, the first support member 661 and the second support member 662 may further include at least one swelling hole for the first battery 691 and the second battery 692.

According to an embodiment, the first housing 610 may include a first rotation support surface 614, and the second housing 620 may include a second rotation support surface 624 corresponding to the first rotation support surface 614. According to an embodiment, the first rotation support surface 614 and the second rotation support surface 624 may include a curved surface corresponding to (naturally connected to) the curved outer surface of the hinge housing 680. According to an embodiment, when the electronic device 600 is in an unfolded state, the first rotation support surface 614 and the second rotation support surface 624 may cover the hinge housing 680 to prevent the hinge housing 680 from being exposed from the rear surface of the electronic device 600 or to expose only a part of the hinge housing 680. According to an embodiment, when the electronic device 600 is in a folded state, the first rotation support surface 614 and the second rotation support surface 624 may rotate along the curved outer surface of the hinge housing 680 and at least partially expose the hinge housing 680 from the rear surface of the electronic device 600.

According to an embodiment, the electronic device 600 may include at least one antenna 676 disposed in the first space 6201. According to an embodiment, at least one antenna 676 may be disposed on the first battery 691 and the first rear cover 640 in the first space 6201. According to an embodiment, the at least one antenna 676 may include, for example, a near field communication (NFC) antenna, a wireless charging antenna, and/or a magnetic secure transmission (MST) antenna. According to an embodiment, the at least one antenna 676 may, for example, perform short-range communication with an external device or wirelessly transmit/receive power required for charging. In some embodiments, the antenna structure may be formed by at least a part of the first lateral member 613 or the second lateral member 623 and/or a part of the first support member 661 and the second support member 662 or a combination thereof.

According to an embodiment, the electronic device 600 may further include at least one electronic component assembly 674 and 675 and/or additional support members 663 and 673 disposed in the first space 6101 and/or the second space 6201. For example, at least one electronic component assembly may include an interface connector port assembly 674 or a speaker assembly 675.

According to an embodiment, the electronic device 600 may include a first waterproof member (WP1) disposed between the first reinforcing plate 637 and the first support member 661 and a second waterproof member (WP2) disposed between the second reinforcing plate 638 and the second support member 662. According to an embodiment, the first waterproof member (WP1) may provide at least one first waterproof space while being disposed between the first reinforcing plate 637 and the first support member 661. According to an embodiment, at least one first waterproof space may accommodate an area corresponding to at least one electronic component (e.g., a camera module or a sensor module) disposed to be supported by the first support member 661. According to an embodiment, the second waterproof member (WP2) may provide a second waterproof space while being disposed between the second reinforcing plate 638 and the second support member 662. According to an embodiment, the second waterproof space may accommodate at least a part of the bending part which is folded toward the rear surface of the first display 630. For example, the second waterproof space may extend from the display panel of the first display 630 and may be disposed to surround at least a part of the bending part which is folded toward the rear surface thereof. Therefore, a control circuit (e.g., a display driver IC (DDI)) and a plurality of electric elements disposed in the bending part may be disposed in the second waterproof space to be protected from external moisture and/or foreign substances.

According to an embodiment, the electronic device 600 may include a waterproof tape 641 disposed between the first rear cover 640 and the first housing 610. According to an embodiment, the electronic device 600 may include a bonding member 651 disposed between the second rear cover 650 and the second housing 620. In some embodiments, the bonding member 651 may be disposed between the second display 655 and the second housing 620. In some embodiments, the waterproof tape 641 may be replaced with the bonding member 651, and the bonding member 651 may be replaced with the waterproof tape 641.

According to an embodiment, at least one hinge device 685 and 687 may include a first hinge device 685 and a second hinge device 687 disposed at one end and the other end in a direction parallel to the folding axis (F), respectively. According to an embodiment, the first hinge device 685 and the second hinge device 687 may have substantially the same configuration. According to an embodiment, the electronic device 600 may include a connection module 686 disposed between the first hinge device 685 and the second hinge device 687. According to an embodiment, the connection module 686 may be arranged through a combination of one or more gears and/or a combination of one or more links. In some embodiments, the connection module 686 may be replaced with the first hinge device 685. In some embodiments, at least one hinge device 685 and 687 may be disposed at one location or three or more locations at designated intervals along a direction parallel to the folding axis (F). According to an embodiment, the electronic device 600 may include a first hinge plate 611 and a second hinge plate 612 connected through at least one hinge device 685 and 687. According to an embodiment, the first hinge plate 611 may form the same plane as the first housing 610 in an unfolded state, and the second hinge plate 612 may form the same plane as the second housing 620 in an unfolded state. According to an embodiment, in a folded state, the flexible display 630 maybe deformed into a waterdrop shape through at least one hinge device 685 and 687 and accommodated in the inner space of the electronic device 600. According to an embodiment, in the folded state, the first hinge plate 611 and the second hinge plate 612 may be moved to support at least a part of the folding area (e.g., the folding area 630c in FIG. 14A) of the flexible display 630, which is deformed into the waterdrop shape, and in the folded state, the first housing 610 and the second housing 620 may be moved to support substantially undeformed flat parts (e.g., the first area 630a and the second area 630b in FIG. 14A) of the flexible display 630. Therefore, the first hinge plate 611 may not form the same plane as the first housing 610 in a folded state, and the second hinge plate 612 may not also form the same plane as the second housing 620.

The at least one hinge device 685 and 687 according to exemplary embodiments of the disclosure may be configured to induce the folding area 630c to be deformed into a designated shape (e.g., a waterdrop shape) in the folded state of the flexible display 630.

The electronic device 600 shown in FIGS. 14A, 14B, 15A, 15B, 16 may include at least some of the components of the electronic device 101 shown in FIG. 1.

The electronic device 600 shown in FIGS. 14A, 14B, 15A, 15B, 16 may include at least some of the components of the electronic device 300 shown in FIGS. 3, 4A, 4B, 4C, 4D, 5, 6A, and 6B.

The electronic device 600 shown in FIGS. 14A, 14B, 15A, 15B, 16 may include at least some of the components of the electronic device 400 shown in FIGS. 7, 8, 9, and 10.

The electronic device 600 shown in FIGS. 14A, 14B, 15A, 15B, 16 may include at least some of the components of the electronic device 500 shown in FIGS. 11, 12, and 13.

The thermal diffusion member 340, 440, or 540 according to an embodiment of the disclosure may be applied to the foldable electronic device 600. The electronic device 600 shown in FIGS. 14A, 14B, 15A, 15B, 16 may include thermal diffusion member 340, 440, or 540.

According to one or more embodiments, the thermal diffusion member 340, 440, or 540 may be disposed between the board 670 and the display 630 and between the battery 691, 692 and the display 630.

According to one or more embodiments, the thermal diffusion member 340, 440, or 540 may be disposed in at least one of the first housing 610 and the second housing 620. For example, the thermal diffusion member 340, 440, or 540 may be disposed in the first housing 610. Alternatively, the thermal diffusion member 340, 440, or 540 may be disposed in the second housing 620. Alternatively, the thermal diffusion member 340, 440, or 540 may be disposed in the first housing 610 and the second housing 620, respectively.

According to one or more embodiments, at least one of the first housing 610 or the second housing 620 may include a structure that supports (or surrounds) at least a portion of the thermal diffusion member 340, 440, or 540. For example, when the thermal diffusion member 340, 440, or 540 are disposed in the first housing 610, the first housing 610 may include the support area 315, 415, or 515 at least in part. When the thermal diffusion member 340, 440, or 540 are disposed in the second housing 620, the second housing 620 may include the support area 315, 415, or 515 at least in part. When the thermal diffusion member 340, 440, or 540 are respectively disposed in the first housing 610 and the second housing 620, the first housing 610 and the second housing 620 may each include the support area 315, 415, or 515 at least in part.

According to one or more embodiments, the thermal diffusion member 340, 440, or 540 may serve to diffuse heat generated from a heat source of the electronic device 600 to other areas of the electronic device 600. For example, the thermal diffusion member 340, 440, or 540 may diffuse heat generated from the board 670 to other areas of the electronic device 600.

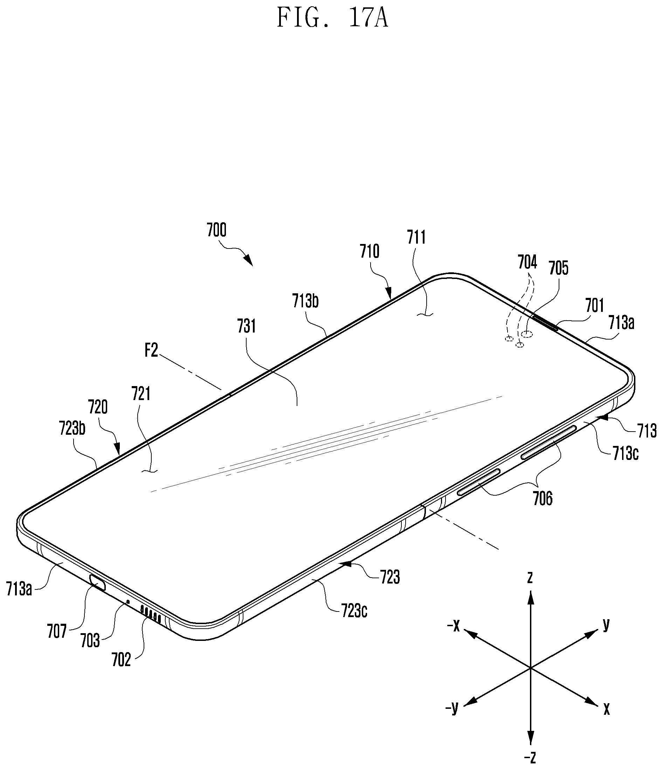

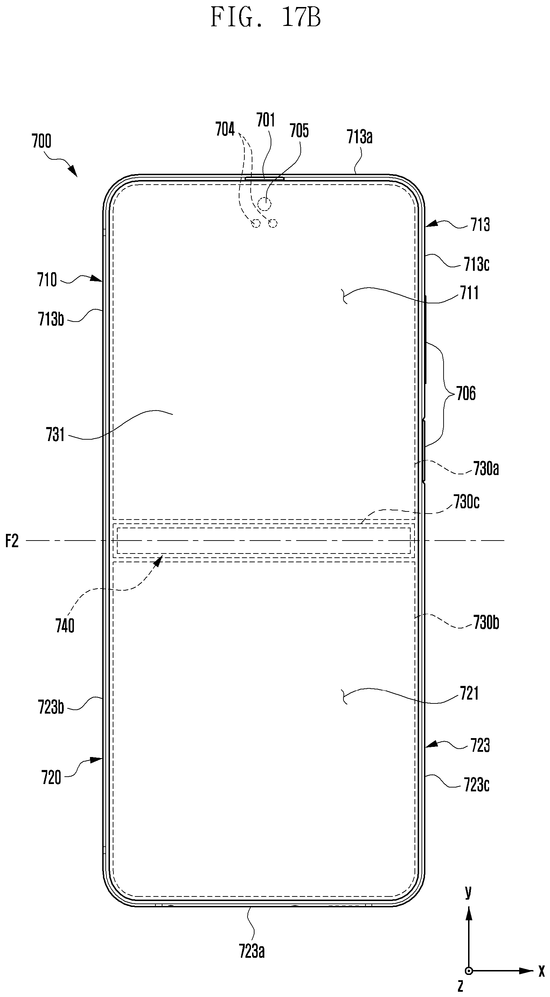

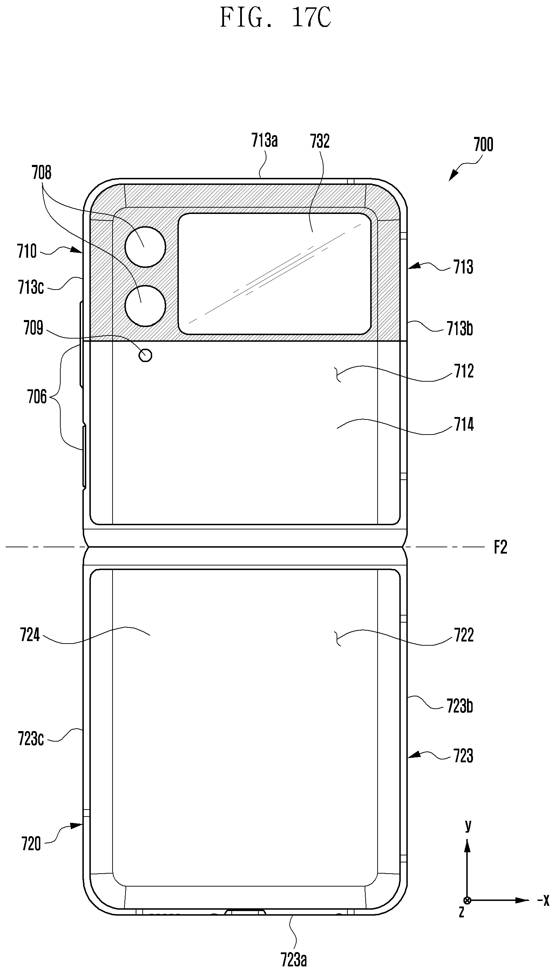

FIG. 17A is a perspective view of an electronic device illustrating an unfolded state (or flat state) of the electronic device according to an embodiment of the disclosure. FIG. 17B is a plan view illustrating a front surface of an electronic device in an unfolded state of the electronic device according to an embodiment of the disclosure. FIG. 17C is a plan view illustrating a rear surface of an electronic device in an unfolded state according to an embodiment of the disclosure.

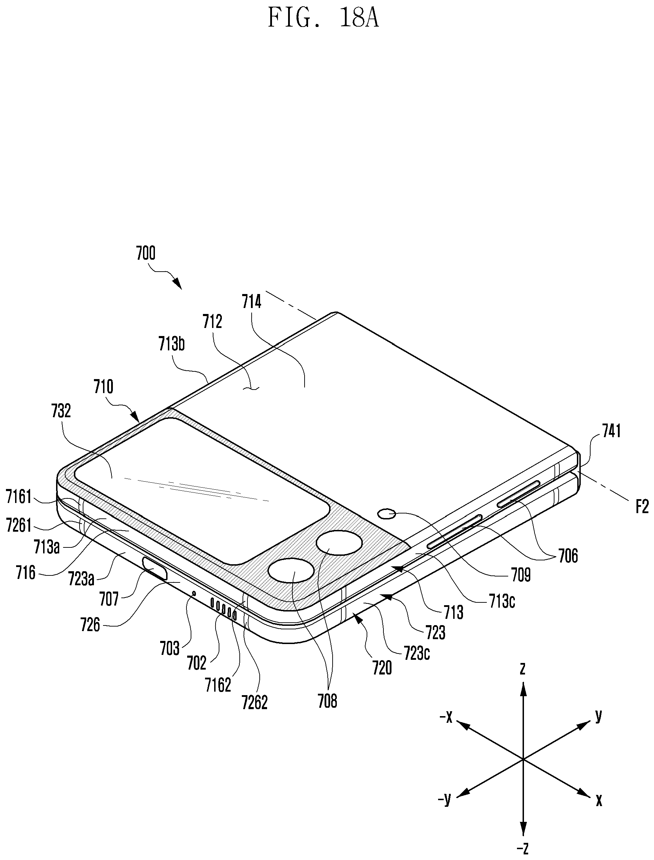

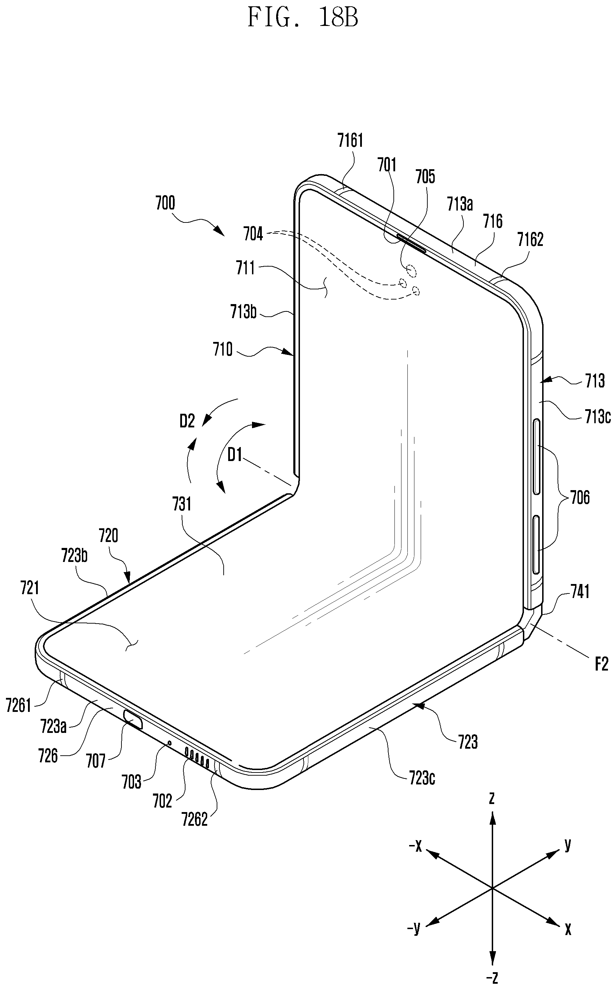

FIG. 18A is a perspective view of an electronic device illustrating a folded state of the electronic device according to an embodiment of the disclosure. FIG. 18B is a perspective view of an electronic device illustrating an intermediate state of the electronic device according to an embodiment of the disclosure.

With reference to FIGS. 17A to 18B, an electronic device 700 may include first and second housings 710 and 720 (e.g., foldable housing structure) combined with each other in a foldable manner based on a hinge device (e.g., hinge device 740 of FIG. 17B). In an embodiment, the hinge device (e.g., hinge device 740 of FIG. 17B) may be disposed in an X-axis direction or in a Y-axis direction. According to an embodiment, the electronic device 700 may include a first display 731 (e.g., flexible display, foldable display, or main display) disposed in an area (e.g., recess) formed by the first and second housings 710 and 720. According to an embodiment, the first housing 710 and the second housing 720 may be disposed on both sides around a folding axis F2, and may have a substantially symmetrical shape about the folding axis F2. According to an embodiment, an angle or a distance between the first housing 710 and the second housing 720 may differ depending on the state of the electronic device 700. For example, depending on whether the electronic device is in an unfolded state (or flat state), in a folded state, or in an intermediate state, the angle or the distance between the first housing 710 and the second housing 720 may differ.

According to an embodiment, in the unfolded state of the electronic device 700, the first housing 710 may include a first surface 711 directed in a first direction (e.g., front direction) (z-axis direction), and a second surface 712 directed in a second direction (e.g., rear direction) (-z-axis direction) opposite to the first surface 711. According to an embodiment, in the unfolded state of the electronic device 700, the second housing 720 may include a third surface 721 directed in the first direction (z-axis direction), and a fourth surface 722 directed in the second direction (-z-axis direction). According to an embodiment, in the unfolded state of the electronic device 700, the first surface 711 of the first housing 710 and the third surface 721 of the second housing 720 may be directed in substantially the same first direction (z-axis direction). In an embodiment, in the folded state of the electronic device 700, the first surface 711 of the first housing 710 and the third surface 721 of the second housing 720 may face each other. According to an embodiment, in the unfolded state of the electronic device 700, the second surface 712 of the first housing 710 and the fourth surface 722 of the second housing 720 may be directed in substantially the same second direction (-z-axis direction). In an embodiment, in the folded state of the electronic device 700, the second surface 712 of the first housing and the fourth surface 722 of the second housing 720 may be directed in opposite directions. For example, in the folded state of the electronic device 700, the second surface 712 may be directed in the first direction (z-axis direction), and the fourth surface 722 may be directed in the second direction (-z-axis direction). In this case, the first display 731may not be viewed from outside (in-folding manner). In an embodiment, the electronic device 700 may be folded so that the second surface 712 of the first housing 710 and the fourth surface 722 of the second housing 720 face each other. In this case, the first display 731 may be disposed to be viewed from the outside (out-folding manner).

According to an embodiment, the first housing 710 (e.g., first housing structure) may include a first lateral member 713 forming the appearance of the electronic device 700, and a first rear cover 714 combined with the first lateral member 713, and forming at least a part of the second surface 712 of the electronic device 700. According to an embodiment, the first lateral member 713 may include a first side surface 713a, a second side surface 713b extending from one end of the first side surface 713a, and a third side surface 713c extending from the other end of the first side surface 713a. According to an embodiment, the first lateral member 713 may be formed in a quadrangular (e.g., square or rectangular) shape through the first side surface 713a, the second side surface 713b, and the third side surface 713c.

According to an embodiment, the second housing 720 (e.g., second housing structure) may include a second lateral member 723 forming the appearance of the electronic device 700 at least partly, and a second lateral cover 724 combined with the second lateral member 723, and forming at least a part of the fourth surface 722 of the electronic device 700. According to an embodiment, the second lateral member 723 may include a fourth side surface 723a, a fifth side surface 723b extending from one end of the fourth side surface 723a, and a sixth side surface 723c extending from the other end of the fourth side surface 723a. According to an embodiment, the second lateral member 723 may be formed in a quadrangular shape through the fourth side surface 723a, the fifth side surface 723b, and the sixth side surface 723c.

According to an embodiment, the first and second housings 710 and 720 are not limited to the illustrated shapes and combinations, but may be implemented by combinations and/or compositions of other shapes or components. In an embodiment, the first lateral member 713 may be integrally formed with the first rear cover 714, and the second lateral member 723 may be integrally formed with the second rear cover 724.

According to an embodiment, in the unfolded state of the electronic device 700, the second side surface 713b of the first lateral member 713 and the fifth side surface 723b of the second lateral member 723 may be connected to each other without a gap. According to an embodiment, in the unfolded state of the electronic device 700, the third side surface 713c of the first lateral member 713 and the sixth side surface 723c of the second lateral member 723 may be connected to each other without a gap. According to an embodiment, in the unfolded state of the electronic device 700, the sum of the lengths of the second side surface 713b and the fifth side surface 723b may be configured to be longer than the length of the first side surface 713a and/or the fourth side surface 723a. According to an embodiment, in the unfolded state of the electronic device 700, the sum of the lengths of the third side surface 713c and the sixth side surface 723c may be configured to be longer than the length of the first side surface 713a and/or the fourth side surface 723a.

With reference to FIGS. 18A and 18B, the first lateral member 713 and/or the second lateral member 723 may be formed of metal, or may further include polymer that is injected into metal. According to an embodiment, the first lateral member 713 and/or the second lateral member 723 may include at least one conductive part 716 and/or 726 electrically segmented through at least one segment part 7161, 7162 and/or 7261, 7262 formed of polymer. In this case, the at least one conductive part 716 and/or 726 may be electrically connected to a wireless communication circuit included in the electronic device 700, and thus may be used as at least a part of an antenna that operates in at least one designated band (e.g., legacy band).

According to an embodiment, the first rear cover 714 and/or the second rear cover 724 may be formed of, for example, at least one of coated or colored glass, ceramic, polymer, or metal (e.g., aluminum, stainless steel (STS), or magnesium) or a combination of at least two thereof.

According to an embodiment, the first display 731 may be disposed to extend from the first surface 711 of the first housing 710 to at least a part of the third surface 721 of the second housing 720 across the hinge device (e.g., hinge device 740 of FIG. 17B). In an embodiment, the first display 731 may include a first area 730a substantially corresponding to the first surface 711, a second area 730b corresponding to the second surface 721, and a third area 730c (e.g., flexible area or folding area) connecting the first area 730a and the second area 730b to each other. According to an embodiment, the third area 730c may be a part of the first area 720a and/or the second area 730b, and may be disposed at a location corresponding to the hinge device (e.g., hinge device 740 of FIG. 17B). According to an embodiment, the electronic device 700 may include a hinge housing 741 (e.g., hinge cover) supporting the hinge device (e.g., hinge device 740 of FIG. 17B). In an embodiment, the hinge housing 741 may be disposed to be exposed to outside when the electronic device 700 is in a folded state, and not to be viewed from the outside as being drawn into an inner space of the first housing 710 and an inner space of the second housing 720 when the electronic device 700 is in an unfolded state.

According to an embodiment, the electronic device 700 may include a second display 731 (e.g., sub-display) disposed separately from the first display 731. According to an embodiment, the second display 731 may be disposed to be exposed at least partly on the second surface 712 of the first housing 710. In an embodiment, when the electronic device 700 is in the folded state, the second display 732 may display at least a part of state information of the electronic device 700 in replacement of at least a part of a display function of the first display 731. According to an embodiment, the second display 732 may be disposed to be viewed from the outside through at least a partial area of the first rear cover 714. In an embodiment, the second display 732 may be disposed on the fourth surface 722 of the second housing 720. In this case, the second display 732 may be disposed to be viewed from the outside through at least a partial area of the second rear cover 724.

According to an embodiment, the electronic device 700 may include at least one of an input device 703 (e.g., microphone), sound output devices 701 and 702, a sensor module 704, camera devices 705 and 708, a key input device 706, or a connector port 707. In an illustrated embodiment, although the input device 703 (e.g., microphone), the sound output devices 701 and 702, the sensor module 704, the camera devices 705 and 708, the key input device 706, or the connector port 707 are illustrated as hole or circular shaped elements formed on the first housing 710 or the second housing 720, they are exemplarily illustrated for explanation, but are not limited thereto. According to an embodiment, the input device 703 may include at least one microphone 703 disposed on the second housing 720. In an embodiment, the input device 703 may include a plurality of microphones 703 disposed to sense the sound direction. In an embodiment, the plurality of microphone 703 may be disposed at proper locations on the first housing 710 and/or the second housing 720. According to an embodiment, the sound output devices 701 and 702 may include at least one speaker 701 and 702. According to an embodiment, the at least one speaker 701 and 702 may include a receiver 701 for call disposed on the first housing 710, and the speaker 702 disposed on the second housing 720. In an embodiment, the input device 703, the sound output devices 701 and 702, and the connector port 707 may be disposed in a space provided in the first housing 710 and/or the second housing 720 of the electronic device 700, and may be exposed to an external environment through at least one hole formed on the first housing 710 and/or the second housing 720. According to an embodiment, the at least one connector port 707 may be used to transmit and receive power and/or data to and from an external electronic device. In an embodiment, the at least one connector port (e.g., ear jack hole) may accommodate a connector (e.g., ear jack) for transmitting and receiving an audio signal to and from the external electronic device. In an embodiment, the hole formed on the first housing 710 and/or the second housing 720 may be commonly used for the input device 703 and the sound output devices 701 and 702. In an embodiment, the sound output devices 701 and 702 may include a speaker (e.g., piezo-electric speaker) that is not exposed through the hole formed on the first housing 710 and/or the second housing 720.

According to an embodiment, the sensor module 704 may generate an electrical signal or a data value corresponding to an internal operation state of the electronic device 700 or an external environment state. According to an embodiment, the sensor module 704 may detect the external environment through the first surface 711 of the first housing 710. In an embodiment, the electronic device 700 may further include at least one sensor module disposed to detect the external environment through the second surface 712 of the first housing 710. According to an embodiment, the sensor module 704 (e.g., illumination sensor) may be disposed to detect the external environment through the first display 731 under the first display 731. According to an embodiment, the sensor module 704 may include at least one of a gesture sensor, a gyro sensor, a barometric pressure sensor, a magnetic sensor, an acceleration sensor, a grip sensor, a color sensor, an infrared (IR) sensor, a biosensor, a temperature sensor, a humidity sensor, an illumination sensor, a proximity sensor, a biosensor, an ultrasonic sensor, or an illumination sensor 704.

According to an embodiment, the camera devices 705 and 708 may include the first camera device 705 (e.g., front camera device) disposed on the first surface 711 of the first housing 710, and the second camera device 708 disposed on the second surface 712 of the first housing 710. In an embodiment, the electronic device 700 may further include a flash 709 disposed near the second camera device 708. According to an embodiment, the camera devices 705 and 708 may include at least one lens, an image sensor, and/or an image signal processor. According to an embodiment, the camera devices 705 and 708 may be disposed so that two or more lenses (e.g., wide angle lens, ultra wide angle lens, or telephoto lens) and two or more image sensors are located on one surface (e.g., first surface 711, second surface 712, third surface 721, or fourth surface 722) of the electronic device 700. In an embodiment, the camera devices 705 and 708 may include lenses for time of flight (TOF) and/or image sensors.

According to an embodiment, the key input device 706 (e.g., key buttons) may be disposed on the third side surface 713c of the first lateral member 713 of the first housing 710. In an embodiment, the key input device 706 may be disposed on at least one side surface of other side surfaces 713a and 713b of the first housing 710 and/or side surfaces 723a, 723b, and 723c of the second housing 720. In an embodiment, the electronic device 700 may not include some or all of the key input devices 706, and the non-included key input device 706 may be implemented in another form, such as a soft key, on the first display 731. In an embodiment, the key input device 706 may be implemented by using the pressure sensor included in the first display 731.

According to an embodiment, one of the camera devices 705 and 708 (e.g., first camera device 705) or the sensor module 704 may be disposed to be exposed through the first display 731. According to an embodiment, the first camera device 705 or the sensor module 704 may be optically exposed to the outside through an opening (e.g., through-hole) formed at least partly on the first display 731 in the inner space of the electronic device 700. According to an embodiment, at least a part of the sensor module 704 may be disposed not to be visually exposed through the first display 731 in the inner space of the electronic device 700. With reference to FIG. 18B, the electronic device 700 may operate to maintain at least one designated folding angle in an intermediate state through the hinge device (e.g., hinge device 740 of FIG. 17B). In this case, the electronic device 700 may control the first display 731 so that different kinds of content are displayed on the display area corresponding to the first surface 711 and the display area corresponding to the third surface 721. According to an embodiment, the electronic device 700 may operate in substantially the unfolded state (e.g., unfolded state of FIG. 17A) and/or in substantially the folded state (e.g., folded state of FIG. 18A) based on a specific folding angle (e.g., angle between the first housing 710 and the second housing 720 when the electronic device 700 is in the intermediate state) through the hinge device (e.g., hinge device 740 of FIG. 17B). In an embodiment, if a pressing force is provided in an unfolding direction (direction D1) in a state where the electronic device 700 is unfolded at the specific folding angle through the hinge device (e.g., hinge device 740 of FIG. 17B), the electronic device 700 may operate to be transitioned to the unfolded state (e.g., unfolded state of FIG. 17A). In an embodiment, if the pressing force is provided in a folding direction (direction D2) in a state where the electronic device 700 is unfolded at the specific folding angle through the hinge device (e.g., hinge device 740 of FIG. 17B), the electronic device 700 may operate to be transitioned to the folded state (e.g., folded state of FIG. 18A). In an embodiment, the electronic device 700 may operate to maintain the unfolded state (not illustrated) at various angles through the hinge device (e.g., hinge device 740 of FIG. 17B) (free-stop function).

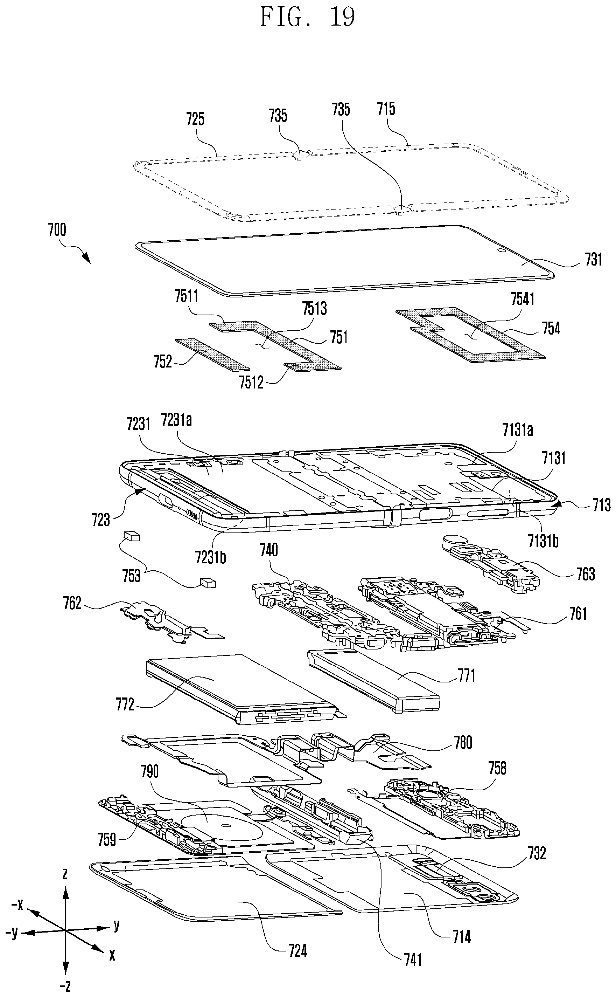

FIG. 19 is an exploded perspective view of an electronic device according to an embodiment of the disclosure.

With reference to FIG. 19, the electronic device 700 may include the first lateral member 713 (e.g., first lateral frame), the second lateral member 723 (e.g., second lateral frame), and the hinge device 740 (e.g., hinge module or hinge structure) rotatably connecting the first lateral member 713 and the second lateral member 723 to each other. According to an embodiment, the electronic device 700 may include a first support member 7131 (e.g., first support plate) extending at least partly from the first lateral member 713, and a second support member 7231 (e.g., second support plate) extending at least partly from the second lateral member 723. According to an embodiment, the first support member 7131 may be integrally formed with the first lateral member 713, or may be structurally combined with the first lateral member 713. In an embodiment, the second support member 7231 may be integrally formed with the second lateral member 723, or may be structurally combined with the second lateral member 723. According to an embodiment, the first display 731may be disposed to be supported by the first support member 7131 and the second support member 7231. According to an embodiment, the electronic device 700 may include the first rear cover 714 combined with the first lateral member 713, and providing a first space together with the first support member 7131, and the second rear cover 724 combined with the second lateral member 723 and providing a second space together with the second support member 7231. In an embodiment, the first lateral member 713 and the first rear cover 714 may be integrally formed with each other. In an embodiment, the second lateral member 723 and the second rear cover 724 may be integrally formed. According to an embodiment, the first housing 710 may include the first lateral member 713, the first support member 7131, and the first rear cover 714. According to an embodiment, the second housing 720 may include the second lateral member 723, the second support member 7231, and the second rear cover 724. According to an embodiment, the electronic device 700 may include the second display 732 disposed to be viewed from the outside through at least a partial area of the first rear cover 714.

According to an embodiment, the electronic device 700 may include a first board 761 (e.g., first board assembly or main printed circuit board) disposed in the first space between the first lateral member 713 and the first rear cover 714, a camera assembly 763, a first battery 771, or a first bracket 751. According to an embodiment, the camera assembly 763 may include a plurality of camera devices (e.g., camera devices 705 and 708 of FIGS. 17A and 18A), and may be electrically connected to the first board 761. According to an embodiment, the first bracket 758 may provide a support structure for supporting the first board 761 and/or the camera assembly 763 and improved stiffness. According to an embodiment, the electronic device 700 may include a second board 762 (e.g., second board assembly or sub-printed circuit board) disposed in the second space between the second lateral member 723 and the second rear cover 724, an antenna 790 (e.g., coil member), a second battery 772, or a second bracket 759. According to an embodiment, the electronic device 700 may include a plurality of electronic components (e.g., wiring member 780 (e.g., flexible printed circuit board (FPCB)) disposed to extend up to the second board 762, the second battery 772, or the antenna 790, and providing an electrical connection) disposed between the second lateral member 723 and the second rear cover 724 across the hinge device 740 from the first board 761. According to an embodiment, the antenna 790 may include a near field communication (NFC) antenna, a wireless charging antenna, and/or a magnetic secure transmission (MST) antenna.

According to an embodiment, the electronic device 700 may also include a first protection cover 715 (e.g., first protection frame or first decoration member) combined along an edge of the first housing 710, and a second protection cover 725 (e.g., second protection frame or second decoration member) combined along an edge of the second housing 720. According to an embodiment, the first protection cover 715 and/or the second protection cover 725 may be formed of a metal or polymer material. According to an embodiment, the first protection cover 715 and/or the second protection cover 725 may be used as the decoration members. In this case, the first display 731 may be disposed so that the edge of the first area 730a is not viewed from the outside between the first housing 710 and the first protection cover 715. According to an embodiment, the first display 731 may be disposed so that the edge of the second area 730b is not viewed from the outside between the second housing 720 and the second protection cover 725.

According to an embodiment, the electronic device 700 may also include a protection cap 735 disposed to protect the edge of the third area (e.g., third area 730c of FIG. 17B) of the first display 731. In this case, the edge of the first display 731 can be protected through the protection cap 735 disposed at a location corresponding to the folding area (e.g., folding area 730c of FIG. 17B).

According to an embodiment, the first support member 7131 may include a first support surface 7131a directed in the first direction (z-axis direction), and a second support surface 7131b directed in the second direction (-z-axis direction) that is opposite to the first direction. According to an embodiment, the second support member 7231 may include a third support surface 7231a directed in the first direction and a fourth support surface 7231b directed in the second direction in the unfolded state of the electronic device 700. According to an embodiment, the first display 731 may be disposed to be supported by the first support surface 7131a of the first support member 7131 and the third support surface 7231a of the second support member 7231.

According to an embodiment, the electronic device 700 may include at least one waterproof member 751, 752, 753, and 754 disposed between the first display 731 and the second support member 7231 and between the first display 731 and the first support member 7131. According to an embodiment, some waterproof members 751, 752, and 753 of the at least one waterproof member 751, 752, 753, and 754 may include the first waterproof member 751 disposed between the first display 731 and the second support member 7231, the second waterproof member 752 connected to the first waterproof member 751, and the third waterproof member 753 that provides a first waterproof space 7513 by connecting one end 7511 of the first waterproof member 751 to one end of the second waterproof member 752 and by connecting the other end 7512 of the first waterproof member 751 to the other end of the second waterproof member 752. In an embodiment, the first waterproof member 751, the second waterproof member 752, and/or the third waterproof member 753 may be integrally formed. According to an embodiment, the waterproof member 754 of the at least one waterproof member 751, 752, 753, and 754 may include the fourth waterproof member 754 that provides a second waterproof space 7541 in the shape of a closed loop disposed between the first display 731 and the first support member 7131. According to an embodiment, a plurality of electronic elements including a control circuit (e.g., display driver IC (DDI)) of the first display 731are disposed in the first sealed waterproof space 7513 formed through the first waterproof member 751, the second waterproof member 752, and the third waterproof member 753 between the first display 731 and the second support member 7231, and thus can be protected from external moisture and/or foreign substances. According to an embodiment, at least one electronic component (e.g., sensor module (e.g., sensor module 704 of FIG. 17A) and/or camera device (e.g., camera device 705 of FIG. 17A)) disposed through the first support member 7131 is disposed in a second waterproof space 7541 formed by the closed loop shape of the fourth waterproof member 754 between the first display 731 and the first support member 7131, and thus can be protected from the external moisture and/or foreign substances. The kinds of the constituent elements disposed in the first waterproof space 7513 and/or the second waterproof space 7541 according to an embodiment are not limited.

The electronic device 700 shown in FIGS. 17A, 17B, 17C, 18A, 18B, and 19 may include at least some of the components of the electronic device 101 shown in FIG. 1.

The electronic device 700 shown in FIGS. 17A, 17B, 17C, 18A, 18B, and 19 may include at least some of the components of the electronic device 300 shown in FIGS. 3, 4A, 4B, 4C, 4D, 5, 6A, and 6B.

The electronic device 700 shown in FIGS. 17A, 17B, 17C, 18A, 18B, and 19 may include at least some of the components of the electronic device 400 shown in FIGS. 7, 8, 9, and 10.

The electronic device 700 shown in FIGS. 17A, 17B, 17C, 18A, 18B, and 19 may include at least some of the components of the electronic device 500 shown in FIGS. 11, 12, and 13.

The thermal diffusion member 340, 440, or 540 according to an embodiment of the disclosure may be applied to the foldable electronic device 700. The electronic device 700 shown in FIGS. 17A, 17B, 17C, 18A, 18B, and 19 may include thermal diffusion member 340, 440, or 540.

According to one or more embodiments, the thermal diffusion member 340, 440, or 540 may be disposed between the board 761, 762 and the first display 731 and between the battery 771, 772 and the first display 731.

According to one or more embodiments, the thermal diffusion member 340, 440, or 540 may be disposed in at least one of the first housing 710 and the second housing 720. For example, the thermal diffusion member 340, 440, or 540 may be disposed in the first housing 710. Alternatively, the thermal diffusion member 340, 440, or 540 may be disposed in the second housing 720. Alternatively, the thermal diffusion member 340, 440, or 540 may be disposed in the first housing 710 and the second housing 720, respectively.

According to one or more embodiments, at least one of the first housing 710 or the second housing 720 may include a structure that supports (or surrounds) at least a portion of the thermal diffusion member 340, 440, or 540. For example, when the thermal diffusion member 340, 440, or 540 are disposed in the first housing 710, the first housing 710 may include the support area 315, 415, or 515 at least in part. When the thermal diffusion member 340, 440, or 540 are disposed in the second housing 720, the second housing 720 may include the support area 315, 415, or 515 at least in part. When the thermal diffusion member 340, 440, or 540 are respectively disposed in the first housing 710 and the second housing 720, the first housing 710 and the second housing 720 may each include the support area 315, 415, or 515 at least in part.

According to one or more embodiments, the thermal diffusion member 340, 440, or 540 may serve to diffuse heat generated from a heat source of the electronic device 700 to other areas of the electronic device 700. For example, the thermal diffusion member 340, 440, or 540 may diffuse heat generated from the board 761, 762 to other areas of the electronic device 700.

An electronic device 300 according to an embodiment of the present disclosure may include a housing 310; a display 320 disposed on one surface of the housing 310; a printed circuit board 380 disposed in an interior of the housing 310; a battery 330 disposed in one direction of the printed circuit board 380 in the interior of the housing 310 and including a first area 331 and a second area 332 having a thickness that is less than a thickness of the first area 331 and formed at an end facing the printed circuit board 380; and a thermal diffusion member 340 disposed between the printed circuit board 380 and the display 320 and between the battery 330 and the display 320, wherein the thermal diffusion member 340 may include a first diffusion area 341 at least a portion of which is disposed to be overlapped with the printed circuit board 380 and at least a portion of which extends to be disposed in a first area 331 of the battery 330; and a second diffusion area 342 disposed between the second area 332 of the battery 330 and the first diffusion area 341 and extending to be overlapped with at least a portion of the second area 332.

In an embodiment, the first diffusion area 341 may extend along a length direction of the electronic device 300, and the second diffusion area 342 may extend along a width direction of the electronic device.

In an embodiment, the housing 310 may include a support area 315 on which a second diffusion area 342 of the thermal diffusion member 340 is disposed, and the second area 332 of the battery 330 may be disposed on one surface of the support area 315, and the second diffusion area 342 of the thermal diffusion member 340 may be disposed on the other surface of the support area 315.

In an embodiment, the support area 315 may include a first support area 3151 disposed between the second diffusion area 342 of the thermal diffusion member 340 and the second area 332 of the battery 330, and a pair of second support areas 3152-1 and 3152-2 connected perpendicularly to the first support area 3151.

In one embodiment, one second support area 3152-1 of the pair of second support areas 3152-1 and 3152-2 may be disposed on one side of the first support area 3151 and the second diffusion area 342, and the remaining second support area 3152-2 of the pair of second support areas 3152-1 and 3152-2 may be disposed on the other side of the first support area 3151 and the second diffusion area 342.

In an embodiment, the support area 315 may include a third support area 3153 that extends in the opposite direction of the second support area 3152 and faces the second area 332 of the battery 330.

In an embodiment, the electronic device 300 may further include at least one flexible printed circuit board 360 electrically connecting internal components of the electronic device 300.

In an embodiment, the electronic device 300 may include at least one flexible printed circuit board 360 at least partially disposed in the second area 332 of the battery 330.

In an embodiment, at least one flexible printed circuit board 360 may be disposed in one direction of the second area 332 of the battery 330, and the second diffusion area 342 of the thermal diffusion member 340 may be disposed in a second direction that is opposite to the one direction of the second area 332 of the battery 330.

In an embodiment, at least one flexible printed circuit board 360 may include a flexible printed circuit board 360 electrically connecting the battery 330 and the printed circuit board 380.

In an embodiment, the thermal diffusion member 440 may be integrally formed with a first diffusion area 441 and a second diffusion area 442.

In an embodiment, the housing 310 may include a placement space 317 having a shape corresponding to at least a portion of the thermal diffusion member, and the thermal diffusion member 340 may be at least partially disposed in the placement space 317.

In an embodiment, the thermal diffusion member 340 may be a first thermal diffusion member 540, and the first thermal diffusion member 540 may be disposed in one direction of the printed circuit board 580.

In an embodiment, the electronic device 500 may further include a second thermal diffusion member 570 one end of which is in contact with the first thermal diffusion member 540 and the other end, the opposite end of the one end, of which is disposed in the other direction, the opposite direction to the one direction, of the printed circuit board 580.

In an embodiment, the housing 510 may include a support area 515 on which the second diffusion area 542 of the first thermal diffusion member 540 is disposed, and the support area 515 may include a diffusion opening 5151 formed at a location where the second thermal diffusion member 570 and the first thermal diffusion member 540 are in contact.

In an embodiment, the second thermal diffusion member 570 may extend at least partially in the height direction of the electronic device 500.

In an embodiment, the electronic device 500 may include a camera module 590 disposed on one side of the printed circuit board 580.

In an embodiment, the second thermal diffusion member 570 may be in contact with the first thermal diffusion member 540 at one end, and may be in contact with the camera module 590 at the other end, which is the opposite end of the one end.

In an embodiment, the battery 330 may include a protection circuit module (PCM) disposed in the second area 332 of the battery 330.

An electronic device 400 according to an embodiment of the present disclosure may include a housing 410; a display 320 disposed on one surface of the housing 410; a printed circuit board 380 disposed in an interior of the housing 410; a battery 330 disposed in one direction of the printed circuit board 380 in the interior of the housing 410 and including a first area 331 and a second area 332 formed at an end facing the printed circuit board 380 that has a thickness less than a thickness of the first area 331; and a thermal diffusion member 440 disposed between the printed circuit board 380 and the display 320 and between the battery 330 and the display 320, wherein the thermal diffusion member 440 may include a first diffusion area 441 at least a portion of which is disposed to be overlapped with the printed circuit board 380 and at least a portion of which extends to be disposed in the first area 331 of the battery 330; and a second diffusion area 442 extending between the second area 332 of the battery 330 and the first diffusion area 441 in a direction perpendicular to the direction in which the first diffusion area 441 extends, and being overlapped with at least portion of the second area 332.

In an embodiment, the housing 410 may include a support area 415 on which a second diffusion area 442 of the thermal diffusion member 440 is disposed, the second area 332 of the battery 330 may be disposed on one surface of the support area 415, and the second diffusion area 442 of the thermal diffusion member 440 may be disposed on the other surface of the support area 415.

In an embodiment, the support area 415 may include a first support area 4151 disposed between the second diffusion area 442 of the thermal diffusion member 440 and the second area 332 of the battery 330, and a pair of second support areas 4152-1, 4152-2 connected perpendicularly to the first support area 4151 and disposed on one side and the other side of the second diffusion area 442.

In an embodiment, the housing 410 may include a placement space 417 having a shape corresponding to at least a portion of the thermal diffusion member, and the thermal diffusion member 440 may be disposed in the placement space 417.

An electronic device 600, 700 according to one or more embodiments may be a foldable electronic device.

According to one or more embodiments, the electronic devices 600, 700 may include a first housing 610, 710 and a second housing 620, 720.

According to one or more embodiments, the first housing 610, 710 and the second housing 620, 720 may be arranged to be foldable relative to each other. The first housing 610, 710 and the second housing 620, 720 may be foldably coupled to each other about the folding axes F1, F2.

According to one or more embodiments, the thermal diffusion member 340, 440, or 540 may be disposed in at least one of the first housing 610, 710 and the second housing 620, 720.

According to one or more embodiments, the support area 315, 415, or 515 may be disposed in at least one of the first housing 610, 710 and the second housing 620, 720.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

An embodiment of the disclosure and the terms used herein are not intended to limit the technological features set forth herein to particular embodiments and include various changes, equivalents, or replacements for a corresponding embodiment. With reference to the description of the diagrams, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), it means that the element may be coupled with the other element directly (e.g., wiredly), wirelessly, or via a third element.

The term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

An embodiment as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORE^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration.

According to an embodiment, operations performed by the module, the program, or another component may be carried out sequentially, in parallel, repeatedly, or heuristically, or one or more of the operations may be executed in a different order or omitted, or one or more other operations may be added.

In addition to the foregoing explanations, the following enumerated aspects, which must not be confused with the appended claims, are also relevant for the present disclosure:
1. An electronic device 300 comprising: a housing 310; a display 320 disposed on one surface of the housing; a printed circuit board 380 disposed in an interior of the housing; a battery 330 disposed on one direction of the printed circuit board in an interior of the housing and including a first area 331 and a second area 332 having a thickness that is less than a thickness of the first area and formed at an end facing the printed circuit board; and a thermal diffusion member 340 disposed between the printed circuit board and the display and between the battery and the display, wherein the thermal diffusion member comprises: a first diffusion area 341 at least a portion of which is disposed to be overlapped with the printed circuit board and at least a portion of which extends to be disposed in the first area of the battery; and a second diffusion area 342 disposed between the second area and the first diffusion area of the battery and extending to be overlapped with at least a portion of the second area.
2. The electronic device of aspect 1, wherein the first diffusion area extends along a length direction of the electronic device; and the second diffusion area extends along a width direction of the electronic device.
3. The electronic device of aspect 1, wherein the housing comprises a support area 315 in which the second diffusion area of the thermal diffusion member is disposed; the second area of the battery is disposed on one surface of the support area; and the second diffusion area of the thermal diffusion member is disposed on the other surface of the support area.
4. The electronic device of aspect 3, wherein the support area comprises: a first support area 3151 disposed between the second diffusion area of the thermal diffusion member and the second area of the battery; and a pair of second support areas 3152-1 and 3152-2 connected perpendicularly to the first support area, wherein one second support area 3152-1 of the pair of second support areas 3152-1 and 3152-2 is disposed on one side of the first support area and the second diffusion area, and wherein the remaining second support area 3152-2 of the pair of second support areas 3152-1 and 3152-2 is disposed on the other side of the first support area and the second diffusion area.
5. The electronic device of aspect 4, wherein the support area comprises a third support area 3153 extending in the opposite direction of the second support area and facing the second area of the battery.
6. The electronic device of aspect 1, further comprising at least one flexible printed circuit board 360 at least partially disposed in the second area of the battery.
7. The electronic device of aspect 6, wherein at least one flexible printed circuit board is disposed in one direction of the second area of the battery; and the second area of the thermal diffusion member is disposed in a direction opposite to one direction of the second area of the battery.
8. The electronic device of aspect 6, wherein at least one flexible printed circuit board comprises a flexible printed circuit board electrically connecting the battery and the printed circuit board.
9. The electronic device of aspect 1, wherein the thermal diffusion member is integrally formed of the first diffusion area and the second diffusion area.
10. The electronic device of aspect 9, wherein the housing comprises a placement space 317 having a shape corresponding to at least a portion of the thermal diffusion member; and at least a portion of the thermal diffusion member is disposed in the placement space 317.
11. The electronic device of aspect 1, wherein the thermal diffusion member is a first thermal diffusion member 540; and the first thermal diffusion member is disposed in one direction of the printed circuit board, and further comprising a second thermal diffusion member 570, one end of which is in contact with the first thermal diffusion member and the other end, the opposite end to the one end, of which is disposed in a direction opposite to the one direction of the printed circuit board.
12. The electronic device of aspect 11, wherein the housing comprises a support area 515 on which the second diffusion area of the first thermal diffusion member is disposed; and the support area comprises a diffusion opening 5151 formed at a location where the second thermal diffusion member and the first thermal diffusion member are in contact.
13. The electronic device of aspect 11, wherein at least a portion of the second thermal diffusion member extends in a height direction of the electronic device.
14. The electronic device of aspect 11, further comprising a camera module 590 disposed on one side of the printed circuit board,
   wherein the second thermal diffusion member is in contact with the first thermal diffusion member at one end, and is in contact with the camera module at the other end, which is opposite to the one end.
15. The electronic device of aspect 1, wherein the battery comprises a protection circuit module (PCM) disposed in the second area of the battery.

## Claims

1. An electronic device (300) comprising:
a display (320);
a rear cover (350);
a housing (310) at least partially disposed between the display (320) and the rear cover (350) such that a first surface of the housing (310) faces toward the display (320) and a second surface opposite to the first surface of the housing (310) faces toward the rear cover (350), the housing (310) including a placement space (317) formed therein and a support structure (315) formed on the second surface, the support structure (315) including a first support portion (3152-1) extended in a first direction substantially perpendicular to the second surface and a second support portion (3151) extended from the first support portion (3152-1) in a second direction substantially perpendicular to the first direction, the first support portion (3152-1) and the second support portion (3151) integrally formed with each other;
a thermal diffusion member portion (341) at least partially disposed in the placement space (317);
a printed circuit board (380) at least partially disposed to face in a third direction opposite to the second direction with respect to the first support portion (3152-1) between a first diffusion portion of the thermal diffusion member portion (341) and the rear cover (350); and
a battery (330) at least partially disposed to face in the second direction with respect to the first support portion (3152-1) between a second diffusion portion of the thermal diffusion member portion (341) and the rear cover (350), the battery (330) including a first battery portion (331) having a first thickness, and a second battery portion (332) extended from the first battery portion (331) in the third direction and having a second thickness thinner than the first battery portion (331),
wherein the second battery portion (332) is at least partially disposed between the second support portion (3151) and the rear cover (350), and
wherein the second support portion (3151) is at least partially disposed between the second diffusion portion of the thermal diffusion member portion (341) and the second battery portion (332).

2. The electronic device (300) of claim 1, wherein the first support portion (3152-1) and the second support portion (3151) are integrally formed with the housing (310).

3. The electronic device (300) of claim 1, wherein any support portion of the support structure (315) is not disposed between the second diffusion portion of the thermal diffusion member portion (341) and the first battery portion (331).

4. The electronic device (300) of claim 1, wherein entirety of the second support portion (3151) is disposed between the first support portion (3152-1) and the first battery portion (331).

5. The electronic device (300) of claim 1, wherein, when viewed in the first direction, the thermal diffusion member portion (341) is overlapped with the first battery portion (331), the second battery portion (332), the first support portion (3152-1), the second support portion (3151), and the printed circuit board (380).

6. The electronic device (300) of claim 1, wherein the first support portion (3152-1) is at least partially disposed between a third diffusion portion between the first and the second diffusion portion of the thermal diffusion member portion (341), and the rear cover (350).

7. The electronic device (300) of claim 1, wherein at least a part of the first support portion (3152-1) is protruded in the third direction.

8. The electronic device (300) of claim 1, wherein the thermal diffusion member portion (341) includes a vapor chamber.

9. The electronic device (300) of claim 1, wherein the second battery portion (332) includes a protection circuit module, PCM, configured to protect the battery (330) from overcharge, overdischarge, or overcurrent.

10. The electronic device (300) of claim 1, wherein the first battery portion (331) includes cells of the battery (330).

11. The electronic device (300) of claim 1, further comprising:
a flexible printed circuit board (360) electrically connected between the printed circuit board (380) and the second battery portion (332),
wherein the flexible printed circuit board (360) is at least partially disposed between the support structure (315) and the rear cover (350).

12. The electronic device (300) of claim 1, further comprising:
a flexible printed circuit board (360) electrically connected between the printed circuit board (380) and the second battery portion (332),
wherein, when viewed in the first direction, the flexible printed circuit board (360) at least partially is overlapped with the second battery portion (332).

13. The electronic device (300) of claim 12, wherein the second support portion (3151) faces one surface of the second battery portion (332), and
wherein the flexible printed circuit board (360) is at least partially disposed on the opposite surface of the second battery portion (332).

14. The electronic device (300) of claim 1, wherein heat generated by the printed circuit board (380) is diffused to other areas of the electronic device (300) via the first diffusion portion and the second diffusion portion.

15. The electronic device of claim 1, wherein the support structure (315) includes a third support portion (3153) extending from the second support portion (3151) in a direction opposite to the first direction toward the second diffusion portion.
